(19) Europäisches Patentamt
European Patent Office
Office européen des brevets

(11) **EP 2 557 137 A1**

(12) **EUROPEAN PATENT APPLICATION**
published in accordance with Art. 153(4) EPC

(43) Date of publication:
**13.02.2013 Bulletin 2013/07**

(21) Application number: **11766018.3**

(22) Date of filing: **08.04.2011**

(51) Int Cl.:
*C09K 11/06* (2006.01)       *C08F 2/44* (2006.01)
*C08K 3/10* (2006.01)       *C08L 101/00* (2006.01)
*C09K 3/10* (2006.01)       *H01L 31/042* (2006.01)

(86) International application number:
**PCT/JP2011/058934**

(87) International publication number:
**WO 2011/126118 (13.10.2011 Gazette 2011/41)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.10.2010   JP 2010229914
20.08.2010   JP 2010184932
09.04.2010   JP 2010090351**

(71) Applicant: **Hitachi Chemical Company, Ltd.
Tokyo 163-0449 (JP)**

(72) Inventors:
• **OKANIWA, Kaoru**
**Tsukuba-shi**
**Ibaraki 300-4247 (JP)**
• **YAMASHITA, Takeshi**
**Tsukuba-shi**
**Ibaraki 300-4247 (JP)**
• **SAWAKI, Taku**
**Tsukuba-shi**
**Ibaraki 300-4247 (JP)**

(74) Representative: **HOFFMANN EITLE
Patent- und Rechtsanwälte
Arabellastrasse 4
81925 München (DE)**

(54) **SPHERICAL PHOSPHOR, SEALING MATERIAL FOR WAVELENGTH CONVERSION SOLAR BATTERY, SOLAR BATTERY MODULE AND METHOD FOR PRODUCING SAME**

(57)   A spherical phosphor is formed by including a fluorescent substance and a transparent material including the fluorescent substance. In addition, a wavelength conversion-type photovoltaic cell sealing material is formed by including a light transmissive resin composition layer including the spherical phosphor and a sealing resin.

EP 2 557 137 A1

## Description

Technical Field

The present invention relates to a spherical phosphor, a wavelength conversion-type photovoltaic cell sealing material using the spherical phosphor, a photovoltaic cell module using the sealing material, and methods for producing them.

Background Art

Conventional crystal silicon photovoltaic cell modules are configured as follows. As a protection glass (also called cover glass) of a module surface, a tempered glass is used in consideration of resistance to shock. On one side of the tempered glass there is an asperity pattern formed by embossment to facilitate adhesion of the glass to a sealing material (which is usually a resin containing an ethylene vinyl acetate copolymer as a main component and also called filler).
In addition, the asperity pattern is formed inside, and the surface of the photovoltaic cell module is smooth. Furthermore, under the protection glass are provided a sealing material for protecting and sealing photovoltaic cells and tab lines, and a back film.

In JP-A-2000-328053 and the like, there have been proposed many methods in which the wavelength of light of UV region or infrared region in sunlight spectrum, which does not contribute to electricity generation, is converted using a fluorescent substance (also called light emission material) to provide a layer that emits light of a wavelength region capable of contributing to electricity generation on a light receiving side of photovoltaic cells.

In addition, for example, JP-A-2006-303033 has proposed a method for including a rare earth complex as a fluorescent substance in a sealing material.
Furthermore, conventionally, for example, as disclosed in JP-A-2003-51605, as a transparent sealing material for photovoltaic cells, there has been widely used an ethylene-vinyl acetate copolymer to which thermosetting properties have been provided.

DISCLOSURE OF INVENTION

Technical Problem

In the proposition described in JP-A-2000-328053 in which light that does not contribute to electricity generation is converted to light of a wavelength region capable of contributing to electricity generation, fluorescent substances are included in a wavelength conversion layer.
However, these fluorescent substances are generally large in shape. Accordingly, when incident sunlight passes through a wavelength conversion film, it does not sufficiently reach photovoltaic cells, thus increasing the proportion of the light that does not contribute to electricity generation. As a result, there has been a problem in which, even when light of UV region is converted to light of visible region by the wavelength conversion layer, the ratio of generated electricity to the incident sunlight (electricity generation efficiency) is not very high.

In the method described in JP-A-2003-51605, a rare earth complex used as a fluorescent substance is easily hydrolyzed together with ethylene vinyl acetate (EVA) widely used as a sealing material and thus can deteriorate over time. In addition, due to the structure thereof, it is difficult to efficiently introduce light with a converted wavelength into the photovoltaic cells. Furthermore, when the rare earth complex is dispersed in EVA, molecules of the rare earth metal easily aggregate with each other, and therefore the complex can be more easily hydrolyzed. In addition, since the aggregate scatters excitation wavelength light, there is a problem in which utilization efficiency of the rare earth metal as a fluorescent substance extremely deteriorates.

The present invention has been accomplished to solve the problems as described above. Objects of the present invention are to provide a spherical phosphor allowing light utilization efficiency in a photovoltaic cell module to be improved to thereby stably improve electricity generation efficiency, and a wavelength conversion-type photovoltaic cell sealing material including the spherical phosphor.

Solution to Problem

The present inventors conducted intensive and extensive investigations to solve the above problems and consequently found that, by forming a wavelength conversion material using a spherical phosphor in which a fluorescent substance is enclosed in a transparent resin, light of a wavelength region that does not contribute to solar power generation in incident sunlight is converted to light of a wavelength that contributes to power generation, and simultaneously found that the material is excellent in humidity resistance and heat resistance. The inventors also found that the spherical phosphor has good dispersibility and can be efficiently introduced into photovoltaic cells without causing the scattering of incident sunlight, thereby completing the present invention. In addition, by using an organic complex of a rare earth metal as the fluorescent substance, particularly, the resistance of the fluorescent substance against humidity can be further improved.

Specifically, the present invention includes the following aspects:

<1> A spherical phosphor including a fluorescent substance and a transparent material.

<2> The spherical phosphor according to the <1>, in which the fluorescent substance is an organic phosphor or a rare earth metal complex.

<3> The spherical phosphor according to either the <1> or the <2>, in which the fluorescent substance is a rare earth metal complex.

<4> The spherical phosphor according to any one of the <1> to the <3>, in which the fluorescent substance is a europium complex.

<5> The spherical phosphor according to any one of the <1> to the <4>, in which the transparent material is a transparent resin.

<6> The spherical phosphor according to any one of the <1> to the <5>, in which the transparent material is a transparent vinyl resin.

<7> The spherical phosphor according to any one of the <1> to the <6>, in which the transparent material is a transparent (meth)acrylic resin.

<8> The spherical phosphor according to any one of the <1> to the <7>, in which a refractive index of the transparent material is lower than that of the fluorescent substance and is 1.4 or higher.

<9> The spherical phosphor according to any one of the <1> to the <8>, in which the spherical phosphor comprises spherical resin particles obtained by emulsion polymerization or suspension polymerization of a vinyl compound composition in which the fluorescent substance is dissolved or dispersed.

<10> The spherical phosphor according to any one of the <1> to the <9>, in which the spherical phosphor comprises spherical resin particles obtained by suspension polymerization of the vinyl compound composition in which the fluorescent substance is dissolved or dispersed.

<11> The spherical phosphor according to the <9> or the <10>, in which the vinyl compound composition includes a bi- or higher-functional vinyl compound.

<12> The spherical phosphor according to the <11>, in which the vinyl compound composition includes a monofunctional (meth)acrylic acid derivative and a bi- or higher-functional (meth)acrylic acid derivative as vinyl compounds.

<13> The spherical phosphor according to any one of the <1> to the <12>, further including a radical scavenger.

<14> A wavelength conversion-type photovoltaic cell sealing material including a light transmissive resin composition layer including the spherical phosphor according to any one of the <1> to the <13> and a sealing resin.

<15> The wavelength conversion-type photovoltaic cell sealing material according to the <14>, in which a content of the spherical phosphor in the resin composition layer is 0.0001 to 10% by mass.

<16> The wavelength conversion-type photovoltaic cell sealing material according to the <14> or the <15>, further including a light transmissive layer other than the resin composition layer.

<17> The wavelength conversion-type photovoltaic cell sealing material according to the <16>, including m layers including the resin composition layer and the light transmissive layer other than the resin composition layer, in which when respective refractive indices of the m layers are $n_1$, $n_2$, ..., $n_{(m-1)}$, and $n_m$ in sequential order from a light incident side, then $n_1 \leq n_2 \leq \cdots \leq n_{(m-1)} \leq n_m$.

<18> A photovoltaic cell module including a photovoltaic cell and the wavelength conversion-type photovoltaic cell sealing material according to any one of the <14> to the <17> disposed on a light receiving surface of the photovoltaic cell.

<19> A method for producing the wavelength conversion-type photovoltaic cell sealing material according to any one of the <14> to the <17>, including preparing the spherical phosphor according to any one of the <1> to the <13>, preparing a resin composition in which the spherical phosphor is mixed or dispersed in a sealing resin, and forming the resin composition into a sheet shape to produce a light transmissive resin composition layer.

<20> A method for producing the photovoltaic cell module according to the <18>, including preparing the wavelength conversion-type photovoltaic cell sealing material according to any one of the <14> to the <17> and disposing the wavelength conversion-type photovoltaic cell sealing material on the light receiving surface side of the photovoltaic cell. Advantageous Effects of Invention

According to the present invention, there can be provided a spherical phosphor allowing for the improvement of light utilization efficiency in a photovoltaic cell module and thereby the stable improvement of electricity generation efficiency, and a wavelength conversion-type photovoltaic cell sealing material including the spherical phosphor.

BRIEF DESCRIPTION OF DRAWINGS

FIG. 1 is a conceptual diagram showing one example of a relationship between a spherical phosphor according to a present embodiment and incident light.
FIG. 2 is a conceptual diagram showing one example of refraction of light on an interface with different refractive indices.
FIG. 3 is a conceptual diagram showing one example of the wavelength dependence of refractive index.
FIG. 4 is a view showing one example of a relationship between content of the spherical phosphor according to the present embodiment and electricity generation efficiency.
FIG. 5 is a view showing one example of a scanning electron microscope photograph of the spherical phosphor according to the present embodiment.
FIG. 6 is a view showing one example of a scanning electron microscope photograph of the spherical phosphor according to the present embodiment.
FIG. 7 is a view showing one example of excitation spectrum of the spherical phosphor according to the present embodiment at a fluorescence wavelength of 621 nm.

BEST MODE FOR CARRYING OUT THE INVENTION

<Spherical Phosphor>

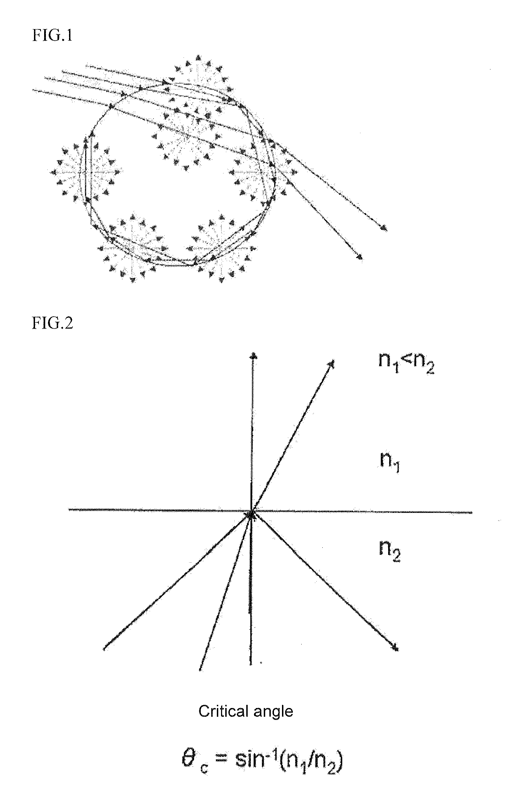

A spherical phosphor of the present invention is formed by including a fluorescent substance and a spherical transparent material enclosing the fluorescent substance.
The spherical phosphor is used, for example, by including it in a wavelength-converting resin composition layer forming a wavelength conversion-type photovoltaic cell sealing material. For example, in the case of a crystal silicon photovoltaic cell, light with wavelengths shorter than 400 nm and longer than 1200 nm in sunlight is not efficiently utilized, and approximately 56% of sunlight energy does not contribute to the generation of electricity due to the spectrum mismatching. The present invention uses a fluorescent substance having a specific shape excellent in humidity resistance and heat resistance, exhibiting good dispersibility, and having a suppressed concentration quenching to utilize sunlight efficiently and stably by wavelength conversion, thereby solving the spectrum mismatching problem. In addition, the present invention maximally improves utilization efficiency of a rare earth metal complex as the fluorescent substance to improve effective light emission efficiency, whereby the invention can contribute to efficient electricity generation while reducing the content of the expensive rare earth complex to a very small level.
That is, the spherical phosphor of the present invention is a fluorescent material excellent in humidity resistance and heat resistance, exhibiting good dispersibility, and having a suppressed concentration quenching. The fluorescent material of the invention enables the utilization efficiency of a rare earth metal complex as an expensive fluorescent substance to be maximally improved and also enables effective light emission efficiency to be improved, thereby improving the electricity generation efficiency of a photovoltaic cell module. In addition, the spherical phosphor of the present invention and a wavelength conversion-type photovoltaic cell sealing material using the spherical phosphor allow the wavelength of light that does not contribute to photovoltaic power generation in incident sunlight to be converted to a wavelength contributing to power generation, and simultaneously allow scattering of the light to be suppressed to efficiently introduce the light into photovoltaic cells.
The spherical phosphor of the present invention has a spherical body shape enclosing the fluorescent substance in the transparent material as a base material. In this manner, by confining the fluorescent substance in the spherical body of the transparent material, capabilities of the fluorescent substance are allowed to be maximally exhibited. This will be described with reference to the drawings. As shown in FIG. 2, when light travels from a high refractive medium to a low refractive medium, total reflection occurs at the interface depending on the relative refractive index of the medium. Typical examples of active application of this phenomenon include various kinds of optical instruments such as optical fiber, optical waveguide, and semiconductor laser. As conditions for total reflection, total reflection occurs when an angle of incidence is larger than a critical angle $\theta_c$ represented by the following formula:

$$\theta_c = \sin^{-1}(n_1/n_2)$$

Meanwhile, substances have an inherent refractive index, which depends on wavelength, and even in the case of a transparent material, the refractive index increases as the wavelength shifts from longer to shorter wavelength. Particularly, when a substance has absorption at a specific wavelength, the refractive index of the substance increases near the wavelength.

In addition, in the case of fluorescent substance, transition from a ground state to an excitation state occurs at its absorption wavelength (excitation wavelength), and upon returning to the ground state, energy as fluorescence (also called light emission) is released. In other words, by mixing a fluorescent substance in a transparent material, the distribution of refractive index can be increased particularly in the excitation wavelength range of the substance, rather than the transparent material (such as a transparent resin) as the base material.

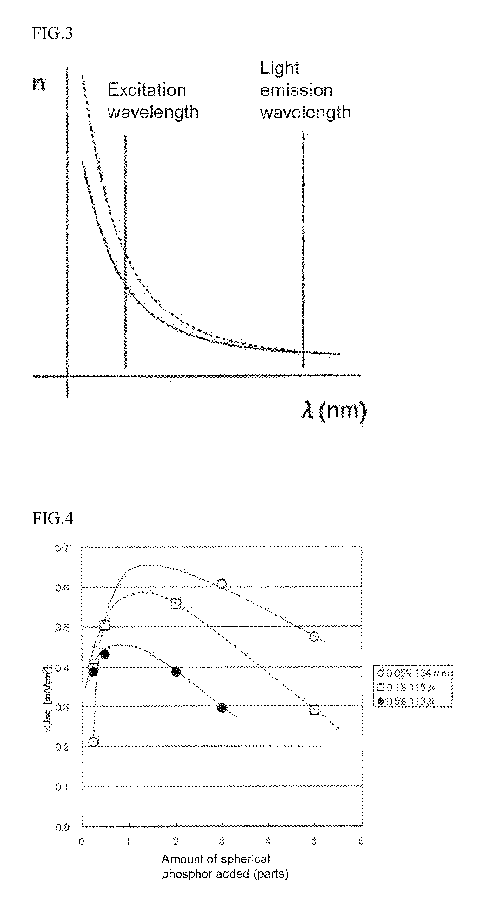

This situation is conceptually shown in FIG. 3. In the drawing, the solid line represents the refractive index distribution of a transparent material as a base material, and the broken line represents a refractive index distribution obtained when a fluorescent substance is included in the transparent material. Particularly, regarding the refractive index, by appropriately selecting the transparent material as a base material of the spherical body, the fluorescent substance, and additionally a medium (a sealing resin), there can be obtained a mutual relationship in which the refractive index inside the spherical body can be made larger than that of the medium (a sealing resin) in the excitation wavelength range and can be made smaller than that thereof (a sealing resin) in the light emission wavelength range, as in FIG. 3.

In such a situation, in the excitation wavelength range, light easily enters into the spherical body with higher refractive index. However, in the spherical body, light hardly goes outside the spherical body due to total reflection inside the spherical body, since the refractive index of the sealing resin outside the spherical body is lower, so that the light repeats total reflection inside the spherical body. Accordingly, it can be thought that the fluorescent substance contained in the spherical body increases the utilization efficiency of excitation light. On the other hand, in the light emission wavelength range, the difference between the refractive index of the spherical body and the refractive index of the medium (for example, a sealing resin) outside the spherical body is not large, so that light will be easily released outside the spherical body. This situation is conceptually shown in FIG. 1.

In this manner, by forming fluorescent substance-containing particles into a spherical shape, as a result, even when using an expensive fluorescent substance in a small amount, a sufficient amount of emission of light having a converted wavelength will be able to be obtained.

Other than that, particularly, the fluorescent substance absorbs excitation wavelength, so that the refractive index in the excitation wavelength range becomes also high, thus easily causing the scattering of light. In addition, when the fluorescent substance aggregates, light scattering becomes larger, and therefore, there may not be any sufficient effect on the improvement of electricity generation efficiency by wavelength conversion to be intended. However, by enclosing the fluorescent substance in the transparent material (preferably, a transparent material with a lower refractive index than that of the fluorescent substance), light scattering caused by the difference of refractive index between the fluorescent substance and the sealing resin can be effectively suppressed.

In addition, when using, as the fluorescent substance, a substance with low humidity resistance, such as a rare earth complex, humidity resistance can be further improved by confining the substance in the spherical body of a transparent material (preferably, a transparent material with humidity resistance),.

The spherical phosphor of the present invention can be not only suitably used in a photovoltaic cell module but also can be applied in wavelength conversion-type agricultural materials, various kinds of optical instruments and display apparatuses using light emission diode excitation, various kinds of optical instruments and display apparatuses using laser excitation, and the like, although the use of the present invention is not limited to the uses thereof.

The spherical phosphor includes at least one fluorescent substance that will be described below and at least one transparent material and has a spherical shape.

Herein, having the spherical shape means that, regarding 100 particles measured using a particle diameter/shape automatic image analysis and measurement apparatus (for example, SYSMEX FPIA-3000 manufactured by Malvern Instruments Limited), an arithmetic mean value of roundness defined in the attached analysis software is 0.90 or more. In addition, the particle diameter of the spherical phosphor can be appropriately selected according to the purpose. For example, when the spherical phosphor is used in a wavelength conversion-type photovoltaic cell sealing material, the particle diameter thereof can be $1\mu m$ to $1000\mu m$, and preferably $10\mu m$ to $500\mu m$. The particle diameter of the spherical phosphor can be measured as a volume mean particle diameter using a laser diffraction/scattering particle size distribution analyzer (for example, LS13320 manufactured by Beckman Coulter, Inc.).

(Fluorescent Substance)

The florescent substance used in the present invention can be appropriately selected according to the purpose, and for example, is preferably a fluorescent substance whose excitation wavelength is 500 nm or less and whose light emission wavelength is longer than that. More preferably, the florescent substance is a compound capable of converting light of a wavelength range having insufficient utilization efficiency in ordinary photovoltaic cells to that of a wavelength range allowing for high utilization efficiency in the photovoltaic cells.

Specifically, preferable examples of the fluorescent substance include organic phosphors, inorganic phosphors, and rare earth metal complexes. Among them, from the aspect of wavelength conversion efficiency, preferred are at least one of organic phosphors and rare earth metal complexes, and more preferred is at least one rare earth metal complex.

-Inorganic Phosphors-

Examples of the inorganic phosphors include fluorescent particles of $Y_2O_2S$: Eu, Mg, or Ti, $Er^{3+}$ ion-containing oxyfluoride crystallized glass, and inorganic fluorescent materials, such as $SrAl_2O_4$:Eu, Dy and $Sr_4Al_{14}O_{25}$:Eu, Dy obtained by adding rare earth elements: europium (Eu) and dysprosium (Dy) to a compound formed from strontium oxide and aluminum oxide, $CaAl_2O_4$:Eu, Dy, and ZnS:Cu.

-Organic Phosphors-

Examples of the organic phosphors include organic dyes such as cyanine dyes, pyridine dyes, and rhodamine dyes, and organic phosphors such as LUMOGEN F Violet 570, Yellow 083, Orange 240, and Red 300 manufactured by BASF Corporation, basic dyes RHODAMINE B manufactured by Taoka Chemical Co. Ltd., SUMIPLAST Yellow FL7G manufactured by Sumika Fine Chemicals Co., Ltd., and MACROLEX Fluorescent Red G and Yellow 10GN manufactured by Bayer Ltd.

-Rare Earth Metal Complex-

A metal forming the rare earth metal complex is, from the aspect of light emission efficiency and light emission wavelength, preferably at least one of europium and samarium, and more preferably europium.

A ligand forming the rare earth metal complex is not particularly limited as long as it can be coordinated to rare earth metal, and can be appropriately selected according to the metal to be used. Above all, from the aspect of light emission efficiency, preferably, the ligand is an organic ligand that can form a complex with at least one of europium and samarium.

In the present invention, although not limited thereto, preferably, the ligand is at least one selected from carboxylic acid, nitrogen-containing organic compounds, nitrogen-containing aromatic heterocyclic compounds, β-diketones, and phosphine oxides, which are neutral ligands.

In addition, as the ligand of the rare earth complex, there may be contained a β-diketone represented by a general formula $R^1COCHR^2COR^3$ (in which, $R^1$ represents an aryl group, an alkyl group, a cycloalkyl group, a cycloalkyl-alkyl group, an aralkyl group, or a substituent thereof, $R^2$ represents a hydrogen atom, an alkyl group, a cycloalkyl group, a cycloalkyl-alkyl group, an aralkyl group, or an aryl group, and $R^3$ represents an aryl group, an alkyl group, a cycloalkyl group, a cycloalkyl-alkyl group, an aralkyl group, or a substituent thereof, respectively).

Specific examples of the β-diketones include acetylacetone, perfluoroacetylacetone, benzoyl-2-furanoylmethane, 1,3-di(3-pyridyl)-1,3-propanedione, benzoyltrifluoroacetone, benzoylacetone, 5-chlorosulfonyl-2-tenoyltrifluoroacetone, bis(4-bromobenzoyl)methane, dibenzoylmethane, d,d-dicamphorylmethane, 1,3-dicyano-1,3-propanedione, p-bis(4,4,5,5,6,6,6-heptafluoro-1,3-hexanedinoyl)benzene, 4,4'-dimethoxybenzoylmethane, 2,6-dimethyl-3,5-heptanedione, dinaphthoylmethane, dipivaloylmethane, bis(perfluoro-2-propoxypropionyl)methane, 1,3-di(2-thienyl)-1,3-propanedione, 3-(trifluoroacetyl)-d-camphor, 6,6,6-trifluoro-2,2-dimethyl-3,5-hexanedione, 1,1,1,2,2,6,6,7,7,7-decafluoro-3.5-heptanedione, 6,6,7,7,8,8,8-heptafluoro-2,2-dimehtyl-3,5-octanedione, 2-furyltrifluoroacetone, hexafluoroacetylacetone, 3-(heptafluorobutyryl)-d-camphor, 4,4,5,5,6,6,6-heptafluoro-1-(2-thienyl)-1,3-hexanedione, 4-methoxydibenzoylmethane, 4-methoxybenzoyl-2-furanoylmethane, 6-methyl-2,4-heptanedione, 2-naphthoyltrifluoroacetone, 2-(2-pyridyl)benzimidazole, 5,6-dihydroxy-1,10-phenanthroline, 1-phenyl-3-methyl-4-benzoyl-5-pyrazole, 1-phenyl-3-methyl-4-(4-butylbenzoyl)-5-pyrazole, 1-phenyl-3-methyl-4-isobutyryl-5-pyrazole, 1-phenyl-3-methyl-4-trifluoroacetyl-5-pyrazole, 3-(5-phenyl-1,3,4-oxadiazol-2-yl)-2,4-pentanedione, 3-phenyl-2,4-pentanedione, 3-[3',5'-bis(phenylmethoxy)phenyl]-1-(9-phenanthyl)-1-propane-1,3-dione, 5,5-dimethyl-1,1,1-trifluoro-2,4-hexanedione, 1-phenyl-3-(2-thienyl)-1,3-propanedione, 3-(t-butylhydroxymethylene)-d-camphor, 1,1,1-trifluoro-2,4-pentanedione, 1,1,1,2,2,3,3,7,7,8,8,9,9,9-tetradecafluoro-4,6-nonanedione, 2,2,6,6-tetramethyl-3,5-heptanedione, 4,4,4-trifluoro-1-(2-naphthyl)-1,3-butanedione, 1,1,1-trifluoro-5,5-dimethyl-2,4-hexanedione, 2,2,6,6-tetramethyl-3,5-heptanedione, 2,2,6,6-tetramethyl-3,5-octanedione, 2,2,6-trimethyl-3,5-heptanedione, 2,2,7-trimethyl-3,5-octanedione, 4,4,4-trifluoro-1-(thienyl)-1,3-butanedione (TTA), 1-(p-t-butylphenyl)-3-(N-methyl-3-pyrrole)-1,3-propanedione (BMPP), 1-(p-t-butylphenyl)-3-(p-methoxyphenyl)-1,3-propanedione (BMDBM), 1,3-diphenyl-1,3-propanedione, benzoylacetone, dibenzoylacetone, diisobutyloylmethane, dipivaloylmethane, 3-methylpentane-2,4-dione, 2,2-dimethylpentane-3,5-dione, 2-methyl-1,3-butanedione, 1,3-butanedione, 3-phenyl-2,4-pentanedione, 1,1,1-trifluoro-2,4-pentanedione, 1,1,1-trifluoro-5,5-dimethyl-2,4-hexanedione, 2,2,6,6-tetramethyl-3,5-heptanedione, 3-methyl-2,4-pentanedione, 2-acetylcyclopentanone, 2-acetylcyclohexanone, 1-heptafloropropyl-3-t-butyl-1,3-propanedione, 1,3-diphenyl-2-methyl-1,3-propanedione, 1-ethoxy-1,3-butanedione, and the like.

Examples of the nitrogen-containing organic compounds, nitrogen-containing aromatic heterocyclic compounds, and phosphine oxides, which are neutral ligands of rare earth metal complex, include 1,10-phenanthroline, 2,2'-bipyridyl, 2,2'-6,2"-terpyridyl, 4,7-diphenyl-1,10-phenanthroline, 2-(2-pyridyl)benzimidazole, triphenylphosphine oxide, tri-n-butylphosphine oxide, tri-n-octylphosphine oxide, and tri-n-butyl phosphate.

As rare earth complexes having the ligands as mentioned above, above all, from the aspect of wavelength conversion efficiency, for example, there may be preferably used Eu(TTA)$_3$phen((1,10-phenanthroline)tris[4,4,4-trifluoro-1-(2-thienyl)-1,3-butanedionato] europium(III)), Eu(BMPP)$_3$phen((1,10-phenanthroline)tris[1-(p-t-butylphenyl)-3-(N-methyl-3-pyrrole)-1,3-propanedionato]europium (III)), and Eu(BMDBM)$_3$phen((1-10-phenanthroline)tris[1-(p-t-butylphenyl)-3-(p-methoxyphenyl)-1,3-propanedionato]europium (III))).

As methods for producing Eu(TTA)$_3$Phen and the like, reference can be made to a method disclosed in "Masaya Mitsuishi, Shinji Kikuchi, Tokuji Miyashita, and Yutaka Amano; J. Master. Chem. 2003, 13, 285-2879".

In the present invention, by using particularly a europium complex as the fluorescent substance, a photovoltaic cell module having high electricity generation efficiency can be formed. The europium complex converts light of UV light region to light of red wavelength region with high wavelength conversion efficiency, and the converted light contributes to electricity generation in photovoltaic cells.

The content of the fluorescent substance in the spherical phosphor of the present invention is not particularly limited and can be appropriately selected according to the purpose and the kind of the fluorescent substance. However, from the aspect of electricity generation efficiency, the content thereof is preferably 0.01 to 1% by mass, and more preferably 0.01 to 0.5% by mass, with respect to a total mass of the spherical phosphor.

(Transparent Material)

In the present invention, the fluorescent substance is contained in the transparent material. In the present invention, the term "transparent" means that a transmittance of light with a wavelength of 400 nm to 800 nm in an optical path length of 1 cm is 90% or more.

The transparent material is not particularly limited as long as it is transparent, and examples of the transparent material include resins such as acrylic resin, methacrylic resin, urethane resin, epoxy resin, polyester, polyethylene, and polyvinyl chloride. Among them, from the aspect of suppressing the scattering of light, preferred is an acrylic resin or methacrylic resin. A monomer compound forming the resin is not particularly limited, but from the aspect of suppressing the scattering of light, preferred is a vinyl compound.

In addition, as a method for including the fluorescent substance in the transparent material and forming the spherical shape, for example, a composition is prepared by dissolving or dispersing the fluorescent substance in a monomer compound and polymerized (emulsion polymerization or suspension polymerization), whereby the spherical phosphor can be prepared. Specifically, for example, a mixture product (hereinafter may be referred to also as "vinyl compound composition") including the fluorescent substance and a vinyl compound is prepared. The composition is emulsified or dispersed in a medium (such as an aqueous medium) to obtain an emulsion product or a suspension product. Then, for example, by polymerization (emulsion polymerization or suspension polymerization) of the vinyl compound included in the emulsion product or the suspension product using a radical polymerization initiator, the spherical phosphor can be formed as spherical resin particles containing the fluorescent substance.

In the present invention, from the aspect of electricity generation efficiency, preferably, a fluorescent substance and vinyl compound-including mixture product (a vinyl compound composition) is prepared and dispersed in a medium (such as an aqueous medium) to obtain a suspension product, and then the polymerization (suspension polymerization) of the vinyl compound included in the suspension product is performed using a radical polymerization initiator to form a spherical phosphor as fluorescent substance-containing spherical resin particles.

(Vinyl Compound)

In the present invention, the vinyl compound is not particularly limited as long as it is a compound having at least one ethylenically unsaturated bond, and without any specific limitation, there can be used an acryl monomer, a methacryl monomer, an acryl oligomer, a methacryl oligomer, or the like that can become a vinyl resin, particularly an acrylic resin or a methacrylic resin upon polymerization reaction. In the present invention, preferably, there are mentioned acryl monomers, methacryl monomers, and the like.

As acryl monomers and methacryl monomers, for example, there may be mentioned acrylic acid, methacrylic acid, and alkylesters thereof. In addition, other vinyl compounds copolymerizable with them may be combined together. These may be used alone or in a combination of two or more kinds thereof.

Examples of acrylic acid alkyl esters and methacrylic acid alkyl esters include unsubstituted alkyl esters of acrylic acid and unsubstituted alkyl esters of methacrylic acid, such as methyl acrylate, methyl methacrylate, ethyl acrylate, ethyl methacrylate, butyl acrylate, butyl methacrylate, 2-ethylhexyl acrylate, and 2-ethylhexyl methacrylate; dicyclopentenyl (meth)acrylate; tetrahydrofurfuryl (meth)acrylate; benzyl(meth)acrylate; compounds obtained by the reaction of polyalcohol with $\alpha,\beta$-unsaturated carboxylic acid (for example, polyethylene glycol di(meth)acrylate (having 2 to 14 ethylene groups), trimethylolpropane di(meth)acrylate, trimethylolpropane tri(meth)acrylate, trimethylolpropane ethoxytri(meth)acrylate, trimethylolpropane propoxytri(meth)acrylate, tetramethylolmethane tri(meth)acrylate, tetramethylolmethane tetra(meth)acrylate, polypropylene glycol di(meth)acrylate (having 2 to 14 propylene groups), dipentaerythritol penta(meth)acrylate, dipentaerythritol hexa(meth)acrylate, bisphenol A polyoxyethylene di(meth)acrylate, bisphenol A dioxyethylene di(meth)acrylate, bisphenol A trioxyethylene di(meth)acrylate, and bisphenol A decaoxyethylene di(meth)acrylate); compounds obtained by the addition of $\alpha,\beta$-unsaturated carboxylic acid to a glycidyl group-containing compound (for example, trimethylolpropane triglycidyl ether triacrylate and bisphenol A diglycidyl ether diacrylate); esterification products of polyvalent carboxylic acid (such as phthalic anhydride) and a substance having a hydroxyl group and an ethylenically unsaturated group (such as $\beta$-hydroxyethyl (meth)acrylate); urethane (meth)acrylate (such as a reaction product of tolylene diisocyanate and a 2-hydroxyethyl (meth)acrylic acid ester, and a reaction product trimethylhexamethylene diisocyanate, cyclohexanedimethanol, and 2-hydroxyethyl (meth)acrylic acid ester); and substituted alkyl esters of acrylic acid or substituted alkyl esters of methacrylic acid in which an alkyl group thereof is substituted with a hydroxyl group, an epoxy group, a halogen group, or the like.

Other examples of the vinyl compound copolymerizable with acrylic acid, methacrylic acid, alkyl esters of acrylic acid, or alkyl esters of methacrylic acid include acryl amide, acrylonitrile, diacetone acrylamide, styrene, and vinyl toluene. These vinyl monomers may be used alone or in a combination of two or more kinds thereof.

The vinyl compound in the present invention can be appropriately selected such that the refractive index of formed resin particles has an intended value, and preferably, at least one selected from alkyl esters of acrylic acid and alkyl esters of methacrylic acid is used.

As the vinyl compound in the present invention, a monofunctional vinyl compound alone may be used to form a vinyl compound composition, or a bi- or higher-functional vinyl compound in addition to a monofunctional vinyl compound may be used to form a vinyl compound composition. Above all, from the aspect of electricity generation efficiency, preferably, at least one monofunctional vinyl compound and at least one bi- or higher-functional vinyl compound are used to form a vinyl compound composition, and more preferably, at least one monofunctional (meth)acrylic acid derivative and at least one bi- or higher-functional (meth)acrylic acid derivative are used to form a vinyl compound composition.

The bi- or higher-functional vinyl compound is not particularly limited as long as it is a compound having at least two ethylenically unsaturated bonds in its molecule. Above all, from the aspect of electricity generation efficiency, the bi- or higher-functional vinyl compound is preferably a two to ten functional vinyl compound, more preferably a two to five functional vinyl compound, and still more preferably a two to five (meth)acrylic acid derivative.

Specific examples of the bi- or higher-functional vinyl compound include compounds obtained by the reaction of polyalcohol with $\alpha,\beta$-unsaturated carboxylic acid (such as polyethylene glycol di(meth)acrylate (having 2 to 14 ethylene groups), ethylene glycol dimethacrylate, trimethylolpropane di(meth)acrylate, trimethylolpropane tri(meth)acrylate, trimethylolpropane ethoxytri(meth)acrylate, trimethylolpropane propoxytri(meth)acrylate, tetramethylolmethane tri(meth)acrylate, tetramethylolmethane tetra(meth)acrylate, polypropylene glycol di(meth)acrylate (having 2 to 14 propylene groups), dipentaerythritol penta(meth)acrylate, dipentaerythritol hexa(meth)acrylate, bisphenol A polyoxyethylene di(meth)acrylate, bisphenol A dioxyethylene di(meth)acrylate, bisphenol A trioxyethylene di(meth)acrylate, and bisphenol A decaoxyethylene di(meth)acrylate);

compounds obtained by the addition of $\alpha,\beta$-unsaturated carboxylic acid to a polyvalent glycidyl group-containing compound (such as trimethylolpropane triglycidyl ether triacrylate and bisphenol A diglycidyl ether diacrylate); and esterification products of polyvalent carboxylic acid (such as phthalic anhydride) and a substance having a hydroxyl group and an ethylenically unsaturated group (such as $\beta$-hydroxyethyl (meth)acrylate).

When the vinyl compound composition includes a monofunctional vinyl compound and a bi- or higher-functional vinyl compound, a content ratio between the monofunctional vinyl compound and the bi- or higher-functional vinyl compound is not particularly limited. Above all, from the aspect of electricity generation efficiency, the amount of the bi- or higher-functional vinyl compound used in a total amount of 100 parts by mass of the vinyl compound is preferably 0.1 to 50 parts by mass, and more preferably 0.5 to 5 parts by mass.

(Radical Polymerization Initiator)

In the present invention, to polymerize the vinyl compound, preferably, a radical polymerization initiator is used. As the radical polymerization initiator, a commonly used radical polymerization initiator can be used without any particular limitation. For example, peroxides or the like are preferable. Specifically, organic peroxides and azo-based radical initiators producing free radicals by heat are preferable.

Examples of the organic peroxides that can be used include isobutyl peroxide, $\alpha$, $\alpha$'-bis(neodecanoylperoxy)diisopropylbenzene, cumyl peroxyneodecanoate, di-n-propyl peroxydicarbonate, bis-s-butyl peroxydicarbonate, 1,1,3,3-tetramethylbutyl neodecanoate, bis(4-t-butylcyclohexyl) peroxydicarbonate, 1-cyclohexyl-1-methylethyl peroxyneodecanoate, bis-2-ethoxyethyl peroxydicarbonate, bis(ethylhexylperoxy)dicarbonate, t-hexyl neodecanoate, bismethoxybutyl peroxydicarbonate, bis(3-methyl-3-methoxybutylperoxy)dicarbonate, t-butyl peroxyneodecanoate, t-hexyl peroxypivalate, 3,5,5-trimethylhexanoyl peroxide, octanoyl peroxide, lauroyl peroxide, stearoyl peroxide, 1,1,3,3-tetramethylbutyl peroxy-2-ethylhexanoate, succinic peroxide, 2,5-dimethyl-2,5-bis(2-ethylhexanoyl)hexane, 1-cyclohexyl-1-methylethyl peroxy-2-ethylhexanoate, t-hexyl peroxy-2-ethylhexanoate, 4-methylbenzoyl peroxide, t-butyl peroxy-2-ethylhexanoate, m-toluonoylbenzoyl peroxide, benzoyl peroxide, t-butyl peroxy isobutyrate, 1,1-bis(t-butylperoxy)-2-methylcyclohexane, 1,1-bis(t-hexylperoxy)-3,3,5-trimethylcyclohexane, 1,1 -bis(t-hexylperoxy)cyclohexane, 1,1-bis(t-butylperoxy)-3,3,5-trimethylcyclohexane, 1,1-bis(t-butylperoxy)cyclohexanone, 2,2-bis(4,4-dibutylperoxycyclohexyl)propane, 1,1 1-bis(t-butylperoxy)cyclododecane, t-hexyl peroxyisopropyl monocarbonate, t-butylperoxymaleic acid, t-butyl peroxy-3,5,5-trimethylhexanoate, t-butyl peroxylaurate, 2,5-dimethyl-2,5-bis(m-toluoylperoxy)hexane, t-butyl peroxyisopropyl monocarbonate, t-butyl peroxy-2-ethylhexyl monocarbonate, t-hexyl peroxybenzoate, 2,5-dimethyl-2,5-bis(benzoylperoxy)hexane, t-butyl peroxyacetate, 2,2-bis(t-butylperoxy)butane, t-butyl peroxybenzoate, n-butyl 4,4-bis(t-butylperoxy)valerate, di-t-butyl peroxyisophthalate, $\alpha,\alpha'$-bis(t-butylperoxy)diisopropylbenzene, dicumyl peroxide, 2,5-dimethyl-2,5-di(t-butylperoxy)hexane, t-butyl cumyl peroxide, di-t-butylperoxy, p-methane hydroperoxide, 2,5-dimethyl-2,5-bis(t-butylperoxy)hexyne, diisopropylbenzene hydroperoxide, t-butyl trimethylsilyl peroxide, 1,1,3,3-tetramethylbutyl hydroperoxide, cumene hydroperoxide, t-hexyl hydroperoxide, t-butyl hydroperoxide, and 2,3-dimethyl-2,3-diphenylbutane.

Examples of the azo-based radical initiators include azobisisobutyronitrile (AIBN, trade name: V-60 manufactured by Wako Pure Chemical Industries, Ltd.), 2,2'-azobis(2-methylisobutyronitrile) (trade name: V-59 manufactured by Wako Pure Chemical Industries, Ltd.), 2,2'-azobis(2,4-dimethylvaleronitrile) (trade name: V-65 manufactured by Wako Pure Chemical Industries, Ltd.), dimethyl-2,2'-azobis(isobutyrate) (trade name: V-601 manufactured by Wako Pure Chemical Industries, Ltd.), and 2,2'-azobis(4-methoxy-2,4-dimethylvaleronitrile) (trade name: V-70 manufactured by Wako Pure Chemical Industries, Ltd.).

An amount of the radical polymerization initiator to be used can be appropriately selected according to the kind of the vinyl compound, the refractive index of the formed resin particles, and the like, and the radical polymerization initiator is used in an amount of ordinary use. Specifically, for example, the radical polymerization initiator may be used in an amount of 0.01 to 2% by mass with respect to the amount of the vinyl compound, and is preferably used in an amount of 0.1 to 1% by mass with respect thereto.

The refractive index of the transparent material in the present invention is not particularly limited. From the aspect of suppressing light scattering, the refractive index of the transparent material is preferably lower than the refractive index of the fluorescent substance. More preferably, the refractive index thereof is lower than the refractive index of the fluorescent substance and a ratio between the refractive index of the transparent material and a refractive index of a sealing resin that will be described below is close to 1. In general, the refractive index of the fluorescent substance is larger than 1.5 and the refractive index of a sealing resin is approximately 1.4 to 1.5. Accordingly, the refractive index of the transparent material is preferably 1.4 to 1.5.

In addition, preferably, the refractive index of the spherical phosphor is higher than that of the sealing resin serving as a dispersion medium at the excitation wavelength of the fluorescent substance and lower than that thereof at the light emission wavelength of the fluorescent substance. In this manner, utilization efficiency of light in the excitation wavelength range is further improved.

(Radical Scavenger)

Preferably, the spherical phosphor of the present invention includes a radical scavenger, together with the fluorescent substance. Including the radical scavenger suppresses the deterioration of the fluorescent substance in the process of producing the spherical phosphor, so that there can be obtained a spherical phosphor having sufficient wavelength conversion capabilities. Accordingly, it is expected that a photovoltaic cell module using the spherical phosphor of the present invention improves light utilization efficiency and thus stably improves electricity generation efficiency. In addition, by including the radical scavenger in the spherical phosphor, the fluorescent substance hardly deteriorates in the spherical phosphor. This increases the range of options for a fluorescent substance that can be included in the spherical phosphor.

The radical scavenger in the present invention is not particularly limited as long as it can sufficiently suppress the deterioration of the fluorescent substance derived from the radical initiator and an intended fluorescent substance-containing spherical phosphor can be obtained. Thus, there can be used an ordinary radical scavenger, such as a hindered amine-based radical scavenger, a hindered phenol-based radical scavenger, a phosphorous-based radical scavenger, or a sulfur-based radical scavenger.

Examples of the hindered amine-based radical scavenger include 1,2,2,6,6-pentamethylpiperidinyl methacrylate, 2,2,6,6-tetramethylpiperidinyl methacrylate, bis(2,2,6,6-tetramethyl-4-piperidine)sebacate, a polymer of dimethyl succinate and 4-hydroxy-2,2,6,6,-tetramethyl-1-piperidineethanol, N,N',N'',N'''-tetrakis-(4,6-bis-(butyl-(N-methyl-2,2,6,6-tetramethylpiperidine-4-yl) amino)-triazine-2-yl)-4,7-diazadecane-1,10-diamine, decanedioic acid bis(2,2,6,6-tetramethyl-1-(octyloxy)-4-piperidinyl)ester, bis(1,2,2,6,6-pentamethyl-4-piperidinyl) [[3,5-bis(1,1-dimethylethyl)-4-hydroxyphenyl]methyl]butylmalonate, a reaction product between a reaction product of cyclohexane and a peroxide N-butyl-2,2,6,6-tetramethyl-4-piperidineamine-2,4,6-trichloro-1,3,5-triazine and 2-aminoethanol (for example, TINUVIN 152 manufactured by BASF Japan Ltd.), bis(1,2,2,6,6-pentamethyl-4-piperidinyl)sebacate, methyl-1,2,2,6,6-pentamethyl-4-piperidylsebacate, and tetrakis(1,2,2,6,6-pentamethyl-4-piperidine)-1,2,3,4-butanetetracarboxylate.

Examples of the hindered phenol-based radical scavenger include 2-t-butyl-4-methoxyphenol, 3-t-butyl-4-methoxyphenol, 2,6-di-t-butyl-4-ethylphenol, 2,2'-methylene-bis(4-methyl-6-t-butylphenol), 4,4'-thiobis-(3-methyl-6-t-butylphenol), 4,4'-butylidene bis(3-methyl-6-t-butylphenol), 1,1,3-tris(2-methyl-4-hydroxy-5-t-butylphenyl)butane, 1,3,5-trimethyl-2,4,6-tris(3,5-di-t-butyl-4-hydroxybenzyl)benzene, and tetrakis [methylene-3-(3',5'-di-t-butyl-4'-hydroxyphenyl) propionate]methane.

Examples of the phosphorus-based radical scavenger include triphenyl phosphite, diphenyl isodecyl phosphite, phenyl diisodecyl phosphite, 4,4'-butylidene-bis(3-methyl-6-t-butylphenyl ditridecyl)phosphite, cyclicneopentane tetrayl bis(nonylphenyl)phosphite, cyclicneopentane tetrayl bis(dinonylphenyl)phosphite, cyclicneopentane tetrayl tris(nonylphenyl)phosphite, cyclicneopentane tetrayl tris(dinonylphenyl)phosphite, 10-(2,5-dihydroxyphenyl)-10H-9-oxa-10-phosphaphcnanthrene-10-oxide, diisodecyl pentaerythritol diphosphite, and tris(2,4-di-t-butylphenyl)phosphite.

Examples of the sulfur-based radical scavenger include dilauryl 3,3'-thiodipropionate, distearyl 3,3'-thiodipropionate, N-cyclohexylthio phthalimide, and N-n-butylbenzene sulfonamide.

Among the above-mentioned radical scavengers, the hindered amine-based radical scavengers are preferably used from the aspect of suppressing the coloring of the transparent material, and more preferably, hindered amine-based radical scavengers having a (meth)acryloyl group are used. By having a (meth)acryloyl group in the molecule of the radical scavenger as mentioned above, a monomer for forming the transparent material and the radical scavenger are polymerized together, whereby the radical scavenger is incorporated into the transparent material. Thereby, the radical scavenger is immobilized in the transparent material to inhibit migration of the radical scavenger, thus inhibiting the bleeding of the radical scavenger out of the transparent material.

Those radical scavengers may be used alone or in a combination of two or more kinds thereof.
In addition, the radical scavenger(s) is(are) used in an amount of extent that does not disturb the progress of radical polymerization so that a spherical phosphor is obtained and does not deteriorate characteristic properties such as transparency and refractive index. Specifically, for example, the radical scavenger(s) may be included in an amount of 0.01 to 5% by mass with respect to the amount of the vinyl compound, and preferably in an amount of 0.1 to 2% by mass with respect thereto.

<Method for Producing Spherical Phosphor>

As a method for producing the spherical phosphor in a spherical shape while including the fluorescent substance and also, if needed, a radical scavenger, in the transparent material, for example, the fluorescent substance and the radical scavenger are dissolved or dispersed in the monomer compound to prepare a composition and then, polymerization (emulsion polymerization or suspension polymerization) of the composition is performed, whereby the spherical phosphor can be prepared. Specifically, for example, a mixture product including a fluorescent substance and a vinyl compound, together with a radical scavenger if needed, is prepared and then emulsified or dispersed in a medium (such as an aqueous medium) to obtain an emulsion product or a suspension product. Next, for example, using a radical polymerization initiator, the vinyl compound included in the emulsion product or the suspension product is polymerized (emulsion polymerization or suspension polymerization), allowing for the formation of a spherical phosphor as spherical resin particles including the fluorescent substance.
In the present invention, preferably, at least one monofunctional vinyl compound and at least one bi- or higher-functional vinyl compound are used as the vinyl compound, and more preferably, at least one monofunctional (meth)acrylic acid derivative and at least one bi-or higher-functional (meth)acrylic acid derivative are used as the vinyl compound.

In the present invention, from the aspect of electricity generation efficiency, preferably, a mixture product including a fluorescent maternal and a vinyl compound is prepared and then dispersed in a medium (such as an aqueous medium) to obtain a suspension product, followed by polymerization (suspension polymerization) of the vinyl compound included in the suspension product using, for example, a radical polymerization initiator, thereby forming the spherical phosphor as spherical resin particles including the fluorescent substance.

From the aspect of improving light utilization efficiency, the spherical phosphor of the present invention has a mean particle diameter of, preferably 1 $\mu$m to 600 $\mu$m, more preferably 5 $\mu$m to 300 $\mu$m, and still more preferably 10 $\mu$m to 250 $\mu$m.
The mean particle diameter of the spherical phosphor is measured using a laser diffraction method. When a weight-cumulative particle size distribution curve is drawn from a smaller particle diameter side, the mean particle diameter of the spherical phosphor corresponds to a particle size in which cumulative weight is 50%. The particle size distribution measurement using a laser diffraction method can be performed using a laser diffraction/scattering particle size distribution analyzer (such as LS 13320 manufactured by Beckman Coulter, Inc.).

<Wavelength Conversion-Type Photovoltaic Cell Sealing Material>

The wavelength conversion-type photovoltaic cell sealing material of the present invention is used as one of a light transmissive layer of a photovoltaic cell module and includes at least one light transmissive resin composition layer having wavelength conversion capabilities. The resin composition layer includes at least one of the spherical phosphors and at least one sealing resin (preferably, a transparent sealing resin), in which the spherical phosphor is dispersed in the sealing resin.

By including the resin composition layer including the spherical phosphor in the wavelength conversion-type photovoltaic cell sealing material, when used as one of light transmissive layers in a photovoltaic cell module, the light utilization efficiency of the module can be improved and thereby electricity generation efficiency can be stably improved.

The scattering of light is correlated with a ratio between the refractive index of the spherical phosphor and the refractive index of the sealing resin. Specifically, regarding the scattering of light, if the ratio between the refractive index of the spherical phosphor and the refractive index of the sealing resin is close to "1", the influence of particle diameter of the spherical phosphor is small and the scattering of light is also small. Particularly, when the present invention is applied to a wavelength conversion-type light transmissive layer of a photovoltaic cell module, preferably, the refractive index ratio in a wavelength region having sensitivity to photovoltaic cells, namely in a wavelength region of 400 to 1200 nm is close to "1". On the other hand, to efficiently cause the total reflection of light of an excitation wavelength range inside the spherical phosphor, the refractive index of the spherical phosphor is preferably higher than the refractive index of the sealing resin as a medium in the excitation wavelength range.

From the above-described requirements, for example, by using a europium complex (preferably, $Eu(TTA)_3Phen$, $Eu(BMPP)_3Phen$, or $Eu(BMDBM)_3Phen$) as the fluorescent substance, polymethyl methacrylate as the transparent material (a base material of the spherical body), and an ethylene-vinyl acetate copolymer (EVA) as the sealing resin, there can be provided a particularly favorable mutual relationship between the refractive indices, from the aspect of excitation wavelength and light emission wavelength, and also from the aspect of sensitivity to photovoltaic cells.

However, in the present invention, preferably, the fluorescent substance, the transparent material, and the sealing resin are appropriately selected such that the mutual relationship between the respective refractive indices of them satisfies the above-described conditions, although the present invention is not limited to the above combination alone.

A preferable amount of the spherical phosphor added in the wavelength converting resin composition layer included in the wavelength conversion-type photovoltaic cell sealing material of the present invention is 0.0001 to 10% by mass in mass concentration with respect to a total amount of a non-volatile content. When the amount of the spherical phosphor added is 0.0001% by mass or more, light emission efficiency increases. In addition, when the amount thereof is 10% by mass or less, scattering of incident light is more effectively suppressed, thereby further improving electricity generation efficiency.

(Sealing Resin)

The wavelength converting resin composition layer in the present invention includes a sealing resin (a transparent sealing resin). Preferable examples of the transparent sealing resin to be used include photocurable resins, thermosetting resins, and thermoplastic resins.

The resin conventionally used as a photovoltaic cell transparent sealing material is, as stated in the above Patent Document 3, an ethylene-vinyl acetate (EVA) copolymer provided with thermosetting properties, which is widely used. However, the present invention is not limited thereto.

When using a photocurable resin as a dispersion medium resin (the transparent sealing resin) of the resin composition for wavelength conversion-type photovoltaic cell sealing material, a resin structure and a photocuring method of the photocurable resin are not particularly limited. For example, in a photocuring method using a photo radical initiator, the resin composition for wavelength conversion-type photovoltaic cell sealing material includes, in addition to the covered phosphor, (A) a photocurable resin, (B) a crosslinking monomer, and (C) a dispersion medium resin including a photoinitiator or the like producing free radicals by light.

Herein, as the photocurable resin (A), there may be used copolymers obtained by copolymerization of acrylic acid or methacrylic acid and an alkyl ester thereof with another vinyl monomer copolymerizable with them as a constituent monomer. These copolymers may be used alone or in a combination of two or more kinds. Examples of alkyl ester of acrylic acid or alkyl ester of methacrylic acid include unsubstituted alkyl esters of acrylic acid or unsubstituted alkyl esters of methacrylic acid, such as methyl acrylate, methyl methacrylate, ethyl acrylate, ethyl methacrylate, butyl acrylate, butyl methacrylate, 2-ethylhexyl acrylate, and 2-ethylhexyl methacrylate, as well as substituted alkyl esters of acrylic acid and substituted alkyl esters of methacrylic acid in which an alkyl group thereof is substituted with a hydroxyl group, an epoxy group, a halogen group, or the like.

In addition, examples of another vinyl monomer copolymerizable with acrylic acid or methacrylic acid, an alkyl ester of acrylic acid, or an alkyl ester of methacrylic acid include acrylamide, acrylonitrile, diacetone acrylamide, styrene, and vinyl toluene. These vinyl monomers may be used alone or in combination of two or more. Additionally, a weight-average molecular weight of the dispersion medium resin as the component (A) is preferably 10,000 to 300,000 from the aspect of film coatability and film coating strength.

Examples of the crosslinking monomer (B) include compounds obtained by the reaction of polyalcohol with $\alpha$,$\beta$-unsaturated carboxylic acid (such as polyethylene glycol di(meth)acrylate (having 2 to 14 ethylene groups), trimethylolpropane di(meth)acrylate, trimethylolpropane tri(meth)acrylate, trimethylolpropane ethoxytri(meth)acrylate, trimethylolpropane propoxytri(meth)acrylate, tetramethylolmethane tri(meth)acrylate, tetramethylolmethane tetra(meth)acrylate, polypropylene glycol di(meth)acrylate (having 2 to 14 propylene groups), dipentaerythritol penta(meth)acrylate, dipentaerythritol hexa(meth)acrylate, bisphenol A polyoxyethylene di(meth)acrylate, bisphenol A dioxyethylene di(meth)acrylate, bisphenol A trioxyethylene di(meth)acrylate, and bisphenol A decaoxyethylene di(meth)acrylate), compounds obtained by the addition of $\alpha$,$\beta$-unsaturated carboxylic acid to a glycidyl group-containing compound (such as trimethylolpropane triglycidyl ether triacrylate and bisphenol A diglycidyl ether diacrylate); and urethane (meth)acrylate (such as a reaction product of tolylene diisocyanate and a 2-hydroxyethyl (meth)acrylic acid ester, and a reaction product of trimethylhexamethylene diisocyanate, cyclohexanedimethanol, and 2-hydroxyethyl (meth)acrylic acid ester).

As particularly preferable crosslinking monomers (B), in an aspect that crosslinking density and reactivity are easily controllable, there are mentioned trimethylolpropane tri(meth)acrylate, dipentaerythritol tetra(meth)acrylate, dipentaerythritol hexa(meth)acrylate, and bisphenol A polyoxyethylene di(meth)acrylate. The above compounds may be used alone or in combination of two or more kinds thereof.

As will be described below, particularly, to increase the refractive index of the wavelength conversion-type photovoltaic cell sealing material or of an underlayer thereof (a side facing photovoltaic cells), it is advantageous to include a bromine or sulfur atom in the photocurable resin (A) and/or the crosslinking monomer (B). Examples of a bromine-including monomer includes NEW FRONTIER BR-31, NEW FRONTIER BR-30, and NEW FRONTIER BR-42M manufactured by Daiichi Kogyo Seiyaku Industry Co., Ltd. Examples of a sulfur-including monomer composition include IU-L2000, IU-L3000, and IU-MS1010 manufactured by Mitsubishi Gas Chemical Company, Inc. However, a bromine or sulfur atom-including monomer (a polymer including the monomer) used in the present invention is not limited to those mentioned above.

The photo initiator (C) is preferably a photo initiator producing free radicals by UV light or visible light. Examples of the photo initiator include benzoin ethers such as benzoin methyl ether, benzoin ethyl ether, benzoin propyl ether, benzoin isobutyl ether, and benzoin phenyl ether, benzophenones such as benzophenone, N,N'-tetramethyl-4,4'-diaminobenzophenone(Michler ketone), and N,N'-tetraethyl-4,4'-diaminobenzophenone, benzyl ketals such as benzyl dimethyl ketal (IRGACURE 651 manufactured by BASF Japan Co., Ltd.) and benzyl diethyl ketal, acetophenones such as 2,2-dimethoxy-2-phenylacetophenone, p-tert-butyldichloroacetophenone, and p-dimethylaminoacetophenone, xanthones such as 2,4-dimethylthioxanthone and 2,4-di-isopropylthioxanthone, or hydroxycyclohexylphenylketone (IRGACURE 184 manufactured by BASF Japan Co., Ltd.), 1-(4-isopropylphenyl)-2-hydroxy-2-methylpropane-1-one (DAROCUR 1116 manufactured by BASF Japan Co., Ltd.) and 2-hydroxy-2-methyl-1-phenylpropane-1-one (DAROCUR 1173 manufactured by BASF Japan Co., Ltd.). These may be used alone or in combination of two or more kinds thereof.

In addition, as photo initiators usable as the photo initiator (C), there may also be mentioned combinations of a 2,4,5-triarylimidazole dimer with 2-mercapto-benzoxazole, Leuco Crystal Violet, tris(4-diethylamino-2-methylphenyl) methane, or the like. Furthermore, there may be used an additive that, by itself, does not have photo initiation properties but will become a sensitizer system exhibiting favorable photo initiation properties as a whole by combination with any of the substances as mentioned above. For example, tertiary amines such as triethanolamine can be used to combine with benzophenone.

In addition, the sealing resin can be thermosetting merely by changing the photo initiator (C) to a thermal initiator. As the thermal initiator (C), preferable are organic peroxides producing free radicals by heat. Examples of the organic peroxides include isobutyl peroxide, $\alpha$,$\alpha$' bis(neodecanoyl peroxy)diisopropylbenzene, cumyl peroxyneodecanoate, bis-n-propylperoxydicarbonate, bis-s-butylperoxydicarbonate, 1,1,3,3-tetramethylbutyl neodecanoate, bis(4-t-butylcyclohexyl)peroxydicarbonate, 1-cyclohexyl-1-methylethylperoxyneodecanoate, di-2-ethoxyethylperoxydicarbonate, bis(ethylhexylperoxy)dicarbonate, t-hexyl neodecanoate, bismethoxybutylperoxydicarbonate, bis(3-methyl-3-methoxybutylperoxy)dicarbonate, t-butylperoxyneodecanoate, t-hexylperoxypivalate, 3,5,5-trimethylhexanoylperoxide, octanoylperoxide, lauroylperoxide, stearoylperoxide, 1,1,3,3-tetramethylbutylperoxy-2-ethylhexanoate, sucnic peroxide, 2,5-dimethyl-2,5-di(2-ethylhexanoyl) hexane, 1-cyclohexyl-1-methylethylperoxy-2-ethylhexanoate, t-hexylperoxy-2-ethylhexanoate, 4-methylbenzoylperoxide, t-butylperoxy-2-ethylhexanoate, m-toluonoyl benzoyl peroxide, benzoyl peroxide, t-butylperoxyisobutylate, 1,1-bis(t-butylperoxy)2-methylcyclohexane, 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-bis(t-butylperoxy)cyclohexane, 2,2-bis(4,4-dibutylperoxycyclohexyl)propane, 1,1- bis(t-butylperoxy)cyclododecane, t-hexyl peroxyisopropyl monocarbonate, t-butylperoxymaleic acid, t-butyl peroxy-3,5,5-trimethylhexanoate, t-butyl peroxylaurate, 2,5-dimethyl-2,5-di(m-toluoylperoxy)hexane, t-butyl peroxyisopropyl monocarbonate, t-butyl peroxy-2-ethylhexyl monocarbonate, t-hexyl peroxybenzoate, 2,5-dimethyl-2,5-bis(benzoylperoxy)hexane, t-butyl peroxyacetate, 2,2-bis(t-butylperoxy)butane, t-butyl peroxybenzoate, n-butyl 4,4-bis(t-butylperoxy)valerate, di-t-butyl peroxyisophthalate, $\alpha,\alpha'$-bis(t-butylperoxy)diisopropylbenzene, dicumyl peroxide, 2,5-di methyl-2,5-di(t-butylperoxy)hexane, t-butyl cumyl peroxide, di-t-butylperoxy-, p-methane hydroperoxide, 2,5-dimethyl-2,5-bis(t-butylperoxy)hexyne, diisopropylbenzene hydroperoxide, t-butyltrimethylsilyl peroxide, 1,1,3,3-tetramethylbutyl hydroperoxide, cumene hydroperoxide, t-hexyl hydroperoxide, t-butyl hydroperoxide, and 2,3-dimethyl-2,3-diphenylbutane.

Although those mentioned above are examples of acryl-based photocurable resins and thermosetting resins, commonly used epoxy-based photocurable resins and thermosetting resins may also be used as the dispersion medium resin of the wavelength conversion-type photovoltaic cell sealing material. However, since the curing of epoxy is ionic, the covered phosphor or the rare earth metal complex as the fluorescent substance may be affected and can cause deterioration or the like, so that acryl-based ones are more preferable.

When using a thermoplastic resin flowing by heating or pressurization as the dispersion medium resin of the wavelength conversion-type photovoltaic cell sealing material, examples of resin used as the dispersion medium resin include (di)enes such as natural rubber, polyethylene, polypropylene, polyvinyl acetate, polyisoprene, poly-1,2-butadiene, polyisobutene, polybutene, poly-2-heptyl-1,3-butadiene, poly-2-t-butyl-1,3-butadiene, and poly-1,3-butadiene, polyethers such as polyoxyethylene ,polyoxypropyrene, polyvinyl ethyl ether, polyvinyl hexyl ether and polyvinyl butyl ether, polyesters such as polyvinyl acetate and polyvinyl propionate; polyurethane; ethyl cellulose; polyvinyl chloride; polyacrylonitrile; polymethacrylonitrile; polysulfone; phenoxy resin; and poly(meth)acrylic acid esters such as polyethyl acrylate, polybutyl acrylate, poly-2-ethylhexyl acrylate, poly-t-butyl acrylate, poly-3-ethoxypropyl acrylate, polyoxycarbonyl tetramethacrylate, polymethyl acrylate, polyisopropyl methacrylate, polydodecyl methacrylate, polytetradecyl methacrylate, poly-n-propyl methacrylate, poly-3,3,5-trimethylcyclohexyl methacrylate, polyethyl methacrylate, poly-2-nitro-2-methylpropyl methacrylate, poly-1,1-diethylpropyl methacrylate, and polymethyl methacrylate.

These thermoplastic resins may be copolymerized in combination of two or more kinds thereof or used by mixing two or more kinds thereof as needed.

Furthermore, as resins copolymerizable with the above resins, epoxy acrylate, urethane acrylate, polyether acrylate, polyester acrylate, and the like may also be used. Particularly in terms of adhesion, urethane acrylate, epoxy acrylate, and polyether acrylate are excellent.

Examples of the epoxy acrylate include (meth)acrylic acid adducts, such as 1,6-hexanediol diglycidylether, neopentylglycol diglycidylether, allylalcohol diglycidylether, resorcinol diglycidylether, adipic acid diglycidylester, phthalic acid diglycidylester, polyethylene glycol diglycidylether, trimethylolpropane triglycidylether, glycerin triglycidylether, pentaerythritol tetraglycidylether, and sorbitol tetraglycidylether.

Polymers having a hydroxyl group in its molecule, such as epoxy acrylate, are effective in improvement of adhesion. Those copolymer resins may be used in combination of two or more kinds as needed. Softening temperature of these resins is preferably 200°C or lower, and more preferably 150°C or lower in terms of the easiness of treatment. Considering that a normal use environment temperature of a sola cell unit is 80°C or lower and processability, the softening temperature the above resins mentioned above is particularly preferably 80 to 120°C.

When a thermoplastic resin is used as the dispersion medium resin, the other structure of the resin composition is not particularly limited as long as the composition includes the above spherical phosphor. However, it is possible to include commonly used components such as a plasticizer, a flame retardant, and a stabilizer.

The dispersion medium resin of the wavelength conversion-type photovoltaic cell sealing material of the present invention may be photocurable, thermosetting, or thermoplastic, as described above, and is not particularly limited. However, as a particularly preferable resin, there is mentioned a composition prepared by mixing a thermal radical initiator in an ethylene-vinyl acetate copolymer widely used as a conventional photovoltaic cell sealing material.

The wavelength conversion-type photovoltaic cell sealing material of the present invention may be formed by a wavelength converting resin composition layer alone, but preferably, in addition to that, further includes a light transmissive layer other than the resin composition layer.

As the light transmissive layer other than the resin composition layer, for example, there may be mentioned a light transmissive layer in which the spherical phosphor is excluded from the wavelength converting resin composition layer. When the wavelength conversion-type photovoltaic cell sealing material of the present invention is formed by a plurality of light transmissive layers, the refractive index(es) of a layer(s) is(are) preferably the same as or higher than that of at least a layer on an incident side.

Specifically, when m pieces of light transmissive layers are set as layer 1, layer 2, ⋯, layer(m-1), and layer m in sequential order from the light incident side and refractive indices of the respective layers are sequentially set as $n_1$, $n_2$, ⋯, $n_{(m-1)}$, and $n_m$, then, preferably, $n_1 \leq n_2 \leq \cdots \leq n_{(m-1)} \leq n_m$.

The refractive index of the wavelength conversion-type photovoltaic cell sealing material of the present invention is not particularly limited, but preferably 1.5 to 2.1 and more preferably 1.5 to 1.9. In addition, when the wavelength conversion-type photovoltaic cell sealing material of the present invention is formed by a plurality of light transmissive layers, preferably, the refractive index of the entire wavelength conversion-type photovoltaic cell sealing material is within the above range.

Preferably, the wavelength conversion-type photovoltaic cell sealing material of the present invention is disposed on a light receiving surface of the photovoltaic cell. Thereby, the material can conform to an uneven shape of the light receiving surface including the texture structure, cell electrodes, and tab lines, without any gap.

From the aspect of handling easiness, preferably, the wavelength conversion-type photovoltaic cell sealing material of the present invention has a sheet shape, and more preferably, has a sheet shape having a light transmissive layer including no spherical phosphor and a light transmissive layer including the spherical phosphor.

<Method for Producing Wavelength Conversion-Type Photovoltaic Cell Sealing Material>

A method for producing the wavelength conversion-type photovoltaic cell sealing material of the present invention includes (1) a process of preparing the spherical phosphor, (2) a process of preparing a resin composition in which the spherical phosphor and the radical scavenger are mixed or dispersed in a sealing resin, and (3) a process of forming the resin composition into a sheet shape to produce a light transmissive resin composition layer. The method may include any other process(es).

- Spherical Phosphor Preparing Process-

At the step of preparing the spherical phosphor, the spherical phosphor may be prepared by purchasing or producing using the above method.

Specifically, the step of preparing the spherical phosphor preferably includes a step of obtaining a spherical phosphor by suspension polymerization of a vinyl compound composition in which a fluorescent substance (preferably, a europium complex) is dissolved or dispersed.

-Resin Composition Preparing Process-

As the method for preparing the resin composition by mixing or dispersing the spherical phosphor and the radical scavenger in a sealing resin, a commonly used method can be used without any limitation. Mixing and kneading may be performed by a roll mixer, a blast mill, or the like such that the spherical phosphor is uniformly dispersed in the sealing resin.

-Sheet Forming Process-

As the method for forming the resin composition into a sheet shape to produce the light transmissive resin composition layer, a commonly used method can be used without any limitation. When using a thermosetting resin as the sealing resin, for example, the composition can be formed into a sheet in a half-cured state using a heated press. The resin composition layer has a thickness of preferably 1 $\mu$m or more and 1000 $\mu$m or less, and more preferably 10 $\mu$m or more and 800 $\mu$m or less.

<Photovoltaic Cell Module>

The present invention also encompasses a photovoltaic cell module including the above-described wavelength conversion-type photovoltaic cell sealing material. The photovoltaic cell module of the present invention includes a photovoltaic cell and the wavelength conversion-type photovoltaic cell sealing material disposed on a light receiving surface of the photovoltaic cell. Thereby, electricity generation efficiency is improved.

The wavelength conversion-type photovoltaic cell sealing material of the present invention is, for example, used as one of light transmissive layers in a photovoltaic cell module having a plurality of light transmissive layers and a photovoltaic cell.

In the present invention, the photovoltaic cell module is, for example, formed by necessary members, such as a reflection preventing film, a protection glass, the wavelength conversion-type photovoltaic cell sealing material, a photovoltaic cell, a back film, a cell electrode, and a tab line. Among these members, as the light transmissive layer having light transmission properties, there are mentioned the reflection preventing film, the protection glass, the wavelength conversion type photovoltaic cell sealing material of the present invention, a SiNx:H layer and an Si layer of the photovoltaic cell, and the like.

In the present invention, a lamination order of the light transmissive layers mentioned above is as follows: usually, sequentially from the light receiving surface of the photovoltaic cell module, the reflection preventing film formed if needed, the protection glass, the wavelength conversion-type photovoltaic cell sealing material of the present invention, and the SiNx:H layer and the Si layer of the photovoltaic cell are laminated.

That is, in the wavelength conversion-type photovoltaic cell sealing material of the present invention, to introduce external light entering from every angle into the photovoltaic cell efficiently with little reflection loss, preferably, the refractive index of the wavelength conversion-type photovoltaic cell sealing material is higher than the refractive indices of the light transmissive layers disposed closer to the light incident side than is the wavelength conversion-type photovoltaic cell sealing material, namely the reflection preventing film and the protection glass, and lower than the refractive indices of the light transmissive layers disposed on a side opposite to the light incident side of the wavelength conversion-type photovoltaic cell sealing material, namely the SiNx:H layer (also called "cell reflection preventing film") and Si layer or the like of the photovoltaic cell.

Specifically, as the light transmissive layers disposed closer to the light incident side than is the wavelength conversion-type photovoltaic cell sealing material, namely, the reflection preventing film and the protection glass, there are used a reflection preventing film with a refractive index of 1.25 to 1.45 and a protection glass with a refractive index of usually 1.45 to 1.55. The light transmissive layers disposed on the side opposite to the light incident side of the wavelength conversion-type photovoltaic cell sealing material, namely the SiNx:H layer (cell reflection preventing film) and the Si layer or the like of the photovoltaic cell, respectively, have usually refractive indices of 1.9 to 2.1 and 3.3 to 3.4, respectively. Accordingly, the refractive index of the wavelength conversion-type photovoltaic cell sealing material of the present invention is preferably 1.5 to 2.1, and more preferably 1.5 to 1.9.

By using the above-described spherical phosphor in the wavelength conversion-type photovoltaic cell sealing material of the present invention, electricity generation efficiency of the photovoltaic cell module is improved. The spherical phosphor suppresses the scattering of light and performs wavelength conversion into light of a wavelength range that can contribute to electricity generation, and the converted light contributes to electricity generation in the photovoltaic cell. Above all, by using a europium complex as the fluorescent substance used in the wavelength conversion-type photovoltaic cell sealing material of the present invention, there can be obtained a photovoltaic cell module having high electricity generation efficiency. The europium complex converts light of UV region to light of red wavelength region with high wavelength conversion efficiency, and the converted light contributes to electricity generation in the photovoltaic cell.

<Method for Producing Photovoltaic cell Module>

A method for producing the photovoltaic cell module of the present invention includes a process of preparing the wavelength conversion-type photovoltaic cell sealing material and a process of disposing the wavelength conversion-type photovoltaic cell sealing material on the light receiving surface side of the photovoltaic cell, and if needed, the method includes any other process(es).

- Wavelength Conversion-Type Photovoltaic cell Sealing Material Preparing Process

At the process of preparing the wavelength conversion-type photovoltaic cell sealing material, the wavelength conversion-type photovoltaic cell sealing material may be prepared by purchasing or producing using the above-described method for producing the wavelength conversion-type photovoltaic cell sealing material.

- Wavelength Conversion-Type Photovoltaic cell Sealing Material Disposing Process

**[0112]** - Using a sheet-shaped resin composition including the spherical phosphor of the present invention, a wavelength conversion-type photovoltaic cell sealing material is formed on the light receiving surface side of the photovoltaic cell to produce a photovoltaic cell module.
Specifically, although it is the same as an ordinary method for producing a crystal silicon photovoltaic cell module, the wavelength conversion-type photovoltaic cell sealing material of the present invention (particularly, preferably having a sheet shape) is used instead of an ordinary sealing material sheet.

Generally, in the silicon crystal photovoltaic cell module, first, on a cover glass as the light receiving surface is mounted a sheet-shaped sealing material (in most cases, which is obtained by forming an ethylene-vinyl acetate copolymer into a thermosetting product using a heat radical initiator). In the present invention, as the sealing material used herein, the wavelength conversion-type photovoltaic cell sealing material of the present invention is used. Next, cells connected by tab lines are mounted thereon and additionally, a sheet-shaped sealing material (in the present invention, the wavelength conversion-type photovoltaic cell sealing material of the invention may be used on the light receiving surface side alone, and on the back surface may be used a conventional one) is mounted, and furthermore, a back sheet is mounted thereon. Then, a module is formed using a vacuum pressure laminator exclusively used for photovoltaic cell modules.

In that case, a heat plate temperature of the laminator is at a temperature level necessary to allow the sealing material to be softened, melted, enclose the cells, and then cured. The heat plate is designed such that such physical changes and chemical changes occur usually at 120 to 180°C, and mostly at 140 to 160°C.

The wavelength conversion-type photovoltaic cell sealing material of the present invention refers to that in a state before being used in the solar module, and specifically refers to that in a half-cured state when using a curing resin. There is no significant difference in refractive index between the wavelength conversion-type photovoltaic cell sealing material in the half-cured state and the wavelength conversion-type photovoltaic cell sealing material after being cured (after the formation of a solar module).

The shape of the wavelength conversion-type photovoltaic cell sealing material of the present invention is not particularly limited, but preferably is sheet-shaped in terms of easiness of solar module production.

The disclosures of Japanese Patent Application No. 2010-090351, Japanese Patent Application No. 2010-229914, and Japanese Patent Application No. 2010-184932 are incorporated herein by reference in their entirety. All documents, patent applications, and technical standards described in the present specification are incorporated herein by reference to the same extent as if each individual document, patent application, or technical standard were specifically and individually indicated to be incorporated by reference.

[EXAMPLES]

Hereinafter, the present invention will be described in more detail with reference to Examples, although the invention is not limited thereto. Unless otherwise specified, "%" and "parts" are based on mass.

(Example 1)

<Synthesis of Fluorescent substance>

In 7 ml of ethanol was dissolved 200 mg of 4,4,4-triftuoro-1-(thienyl)-1,3-butanedione (TTA), and into the mixture was added 1.1 ml of 1M sodium hydroxide to mix together. In 7 ml of ethanol was dissolved 6.2 mg of 1,10-phenanthroline, and this mixture was added to the previous mixture solution. After stirring the solution for 1 hour, a 3.5 ml aqueous solution containing 103 mg of $EuCl_3 \cdot 6H_2O$ was added to obtain a precipitate. The precipitate was filtered, washed with ethanol, and then dried to obtain a fluorescent substance $Eu(TTA)_3Phen$.

<Production of Spherical Phosphor>

Amounts of 0.05 g of the fluorescent substance $Eu(TTA)_3Phen$ obtained above, 100 g of methyl methacrylate, 0.2 g of lauroyl peroxide as a heat radical initiator, respectively, were measured and placed in a 200 ml screw tube to stir and mix together using an ultrasonic cleaner and a mix rotor. Into a separable flask equipped with a cooling tube were added 500 g of deionized water and 4 g of polyvinyl alcohol 1.8% solution as a surfactant to stir the mixture solution. The previously prepared mixture solution of methyl methacrylate was added to the mixture solution to stir at 2000 rpm for 20 seconds using a homogenizer. The resultant solution was heated to 60°C while stirring at 350 rpm to allow it to react for 3 hours. In the obtained suspension, particle diameters were measured using Beckman Coulter LS 13320 to obtain a volume mean diameter of 104 μm. The precipitate was filtered, washed with deionized water, and dried at 60°C to obtain a spherical phosphor A by suspension polymerization.

The obtained spherical phosphor A was observed through a microscope or a scanning electron microscope, and it was confirmed that the obtained spherical phosphor A was spherical.

In addition, regarding the product obtained by curing methyl methacrylate forming the spherical phosphor A using the heat radical initiator, a transmittance of light at 400 to 800 nm in an optical path length of 1 cm was calculated and a transmittance of 90% or more was obtained.

<Preparation of Resin Composition for Wavelength Conversion-Type Photovoltaic cell Sealing Material>

A mixture product containing 100 g of ULTRASEN 634: an ethylene-vinyl acetate resin manufactured by Tosoh Corporation as a transparent sealing resin (dispersion medium resin), 1.5 g of LUPEROX 101: a peroxide heat radical initiator manufactured by Arkema Yoshitomi, Ltd., 0.5 g of SZ6030: a silane coupling agent manufactured by Toray Dow Corning Co. Ltd., and 0.25 g of the spherical phosphor was mixed and kneaded by a roll mixer adjusted to 100°C to obtain a resin composition for wavelength conversion-type photovoltaic cell sealing material.

<Production of Wavelength Conversion-Type Photovoltaic cell Sealing Material Sheet>

Approximately 30g of the resin composition for wavelength conversion-type photovoltaic cell sealing material obtained above was sandwiched by a release sheet to be formed into a sheet shape using a stainless steel spacer with a thickness of 0.6 mm and a press with a heat plate adjusted to 80°C. The obtained sheet-shaped wavelength conversion-type photovoltaic cell sealing material had a refractive index of 1.5.

<Production of Photovoltaic cell Sealing Material Sheet for Back Side>

In the production of the wavelength conversion-type photovoltaic cell sealing material sheet above, instead of the resin composition for wavelength conversion-type photovoltaic cell sealing material, using a resin composition prepared in the same manner as above except for including no spherical phosphor, a photovoltaic cell sealing material sheet for back side was produced by the same method as above.

<Production of Wavelength Conversion-Type Photovoltaic cell Module>

On a tempered glass (manufactured by Asahi Glass Co., Ltd., refractive index: 1.5) as a protection glass was mounted the wavelength conversion-type photovoltaic cell sealing material sheet, and thereon were mounted photovoltaic cells adapted to externally take out electromotive force such that light receiving surfaces of the cells faced downwardly. Additionally, the photovoltaic cell sealing material sheet for back side and a PET film (trade name: A-4300 manufactured by Toyobo Co., Ltd.) as a back film were mounted and then, lamination was done using a vacuum laminator to produce a wavelength conversion-type photovoltaic cell module.
Additionally, on the photovoltaic cells used are formed a cell reflection preventing film with a refractive index of 1.9.

<Evaluation of Photovoltaic cell Characteristics>

Using a solar simulator (WXS-1555-10, AM 1.5 G, manufactured by Wacom Electric Co., Ltd.) as an artificial sunlight, a short-circuit current density Jsc in the state of the cells before module sealing and a short-circuit current density Jsc in the state thereof after module sealing, respectively, were measured by an I-V curve tracer (MP-160 manufactured by Eko Instruments, Co., Ltd.) electric current-voltage characteristics based on JIS-C8914, and a difference ($\Delta$Jsc) between them was obtained for evaluation. As a result, the $\Delta$Jsc was 0.212 mA/cm$^2$. Table 1 and FIG. 4 show the measurement results.
FIG. 4 shows a relationship between the amount of the spherical phosphor included in the wavelength converting resin composition layer and electricity generation efficiency in each particle diameter of the spherical phosphor.

<Evaluation of High Temperature/High Humidity Resistance of Light Emission>

In the same method as in the above <Production of Wavelength Conversion-Type Photovoltaic cell Module>, using a sheet of blue glass of 5 cm $\times$ 10 cm $\times$ 1 mm as the protection glass, thereon was mounted the wavelength conversion-type photovoltaic cell sealing material sheet. Then, as a back film, a PET film (trade name: A-4300 manufactured by Toyobo Co., Ltd.) was mounted thereon and lamination was done using a vacuum laminator to form a test piece.
Using a handy UV lamp: SLUV-4 manufactured by As One Corporation, the test piece was irradiated with light of 365 mn to observe the presence or absence of red light emission. In addition, the test piece was placed in a temperature and humidity testing chamber adjusted to 85°C and 85% RH, and after an appropriate time interval, the presence or absence of red light emission was observed in the same manner as above. As a result, light emission was confirmed until 2500 hours. Table 1 shows results of the observation.

(Example 2)

Evaluations of $\Delta$Jsc and high temperature/high humidity resistance of light emission were conducted in the same procedures and methods as those described above except that the content of the spherical phosphor A was changed to 0.5 g instead of 0.25 g in <Preparation of Resin Composition for Wavelength Conversion-Type Photovoltaic cell Sealing Material> of Example 1. As a result, the $\Delta$Jsc was 0.499 mA/cm$^2$, and light emission was confirmed until 2500 hours. Table 1 and FIG. 4 show results of the measurement and results of the observation.

(Example 3)

Evaluations of $\Delta$Jsc and high temperature/high humidity resistance of light emission were conducted in the same procedures and methods as those described above except that the content of the spherical phosphor A was changed to 3g instead of 0.25 g in <Preparation of Resin Composition for Wavelength Conversion-Type Photovoltaic cell Sealing Material> of Example 1. As a result, the ΔJsc was 0.607 mA/cm$^2$, and light emission was confirmed until 2500 hours. Table 1 and FIG. 4 show results of the measurement and results of the observation.

(Example 4)

Evaluations of ΔJsc and high temperature/high humidity resistance of light emission were conducted in the same procedures and methods as those described above except that the content of the spherical phosphor A was changed to 5g instead of 0.25 g in <Preparation of Resin Composition for Wavelength Conversion-Type Photovoltaic cell Sealing Material> of Example 1. As a result, the ΔJsc was 0.474 mA/cm$^2$, and light emission was confirmed until 2500 hours. Table 1 and FIG. 4 show results of the measurement and results of the observation.

(Example 5)

A suspension of spherical phosphor was obtained in the same manner as above except that the amount of the fluorescent substance Eu (TTA)$_3$Phen added was changed to 0.1 g instead of 0.05 g in <Production of Spherical Phosphor> of Example 1. In the suspension, particle diameters were measured using Beckman Coulter LS 13320 to obtain a volume average diameter of 115 μm.
The precipitate was filtered, washed with deionized water, and dried at 60°C to obtain a spherical phosphor B by suspension polymerization.
Evaluations of ΔJsc and high temperature/high humidity resistance of light emission were conducted in the same procedures and methods as those described above except that 0.25 g of the spherical phosphor B obtained above as a spherical phosphor was used in <Preparation of Resin Composition for Wavelength Conversion-Type Photovoltaic cell Sealing Material> of Example 1. As a result, the ΔJsc was 0.396 mA/cm$^2$, and light emission was confirmed until 2500 hours. Table 1 and FIG. 4 show results of the measurement and results of the observation.

(Example 6)

Evaluations of ΔJsc and high temperature/high humidity resistance of light emission were conducted in the same procedures and methods as those described above except that the content of the spherical phosphor B was changed to 0.5 g instead of 0.25 g in <Preparation of Resin Composition for Wavelength Conversion-Type Photovoltaic cell Sealing Material> of Example 5. As a result, ΔJsc was 0.503 mA/cm$^2$, and light emission was confirmed until 2500 hours. Table 1 and FIG. 4 show results of the measurement and results of the observation.

(Example 7)

Evaluations of ΔJsc and high temperature/high humidity resistance of light emission were conducted in the same procedures and methods as those described above except that the content of the spherical phosphor B was changed to 2 g instead of 0.25 g in <Preparation of Resin Composition for Wavelength Conversion-Type Photovoltaic cell Sealing Material> of Example 5. As a result, ΔJsc was 0.557 mA/cm$^2$, and light emission was confirmed until 2500 hours. Table 1 and FIG. 4 show results of the measurement and results of the observation.

(Example 8)

Evaluations of ΔJsc and high temperature/high humidity resistance of light emission were conducted in the same procedures and methods as those described above except that the content of the spherical phosphor B was changed to 5 g instead of 0.25 g in <Preparation of Resin Composition for Wavelength Conversion-Type Photovoltaic cell Sealing Material> of Example 5. As a result, the ΔJsc was 0.290 mA/cm$^2$, and light emission was confirmed until 2500 hours. Table 1 and FIG. 4 show results of the measurement and results of the observation.

(Example 9)

A suspension of spherical phosphor was obtained in the same method as above except that the amount of the fluorescent substance Eu(TTA)$_3$Phen added was changed to 0.5 g instead of 0.05 g in <Production of Spherical Phosphor> of Example 1. In the suspension, particle diameters were measured using Beckman Coulter LS 13320 to obtain a volume average diameter of 113 μm. The precipitate was filtered, washed with deionized water, and dried at 60°C to obtain a spherical phosphor C by suspension polymerization.
Evaluations of ΔJsc and high temperature/high humidity resistance of light emission were conducted in the same procedures and methods as those described above except that 0.25 g of the spherical phosphor C obtained above as a spherical phosphor was used in <Preparation of Resin Composition for Wavelength Conversion-Type Photovoltaic cell Sealing Material> of Example 1. As a result, the $\Delta$Jsc was 0.387 mA/cm$^2$, and light emission was confirmed until 2500 hours. Table 1 and FIG. 4 show results of the measurement and results of the observation.

(Example 10)

Evaluations of $\Delta$Jsc and high temperature/high humidity resistance of light emission were conducted in the same procedures and methods as those described above except that the content of the spherical phosphor C was changed to 0.5 g instead of 0.25 g in <Preparation of Resin Composition for Wavelength Conversion-Type Photovoltaic cell Sealing Material> of Example 9. As a result, the $\Delta$Jsc was 0.437 mA/cm$^2$, and light emission was confirmed until 2500 hours. Table 1 and FIG. 4 show results of the measurement and results of the observation.

(Example 11)

Evaluations of $\Delta$Jsc and high temperature/high humidity resistance of light emission were conducted in the same procedures and methods as those described above except that the content of the spherical phosphor C was changed to 2 g instead of 0.25 g in <Preparation of Resin Composition for Wavelength Conversion-Type Photovoltaic cell Sealing Material> of Example 9. As a result, the $\Delta$Jsc was 0.388 mA/cm$^2$, and light emission was confirmed until 2500 hours. Table 1 and FIG. 4 show results of the measurement and results of the observation.

(Example 12)

Evaluations of $\Delta$Jsc and high temperature/high humidity resistance of light emission were conducted in the same procedures and methods as those described above except that the content of the spherical phosphor C was changed to 3 g instead of 0.25 g in Example 9: <Preparation of Resin Composition for Wavelength conversion-type Photovoltaic cell Sealing Material>. As a result, the $\Delta$Jsc was 0.295 mA/cm$^2$, and light emission was confirmed until 2500 hours. Table 1 and FIG. 4 show results of the measurement and results of the observation.

(Comparative Example 1)

Evaluations of $\Delta$Jsc and high temperature/high humidity resistance of light emission were conducted in the same procedures and methods as those described above except that 0.01 g of the fluorescent substance Eu(TTA)$_3$Phen was used as it was instead of the spherical phosphor A in <Preparation of Resin Composition for Wavelength Conversion-Type Photovoltaic cell Sealing Material> of Example 1. As a result, the $\Delta$Jsc was -0.18 mA/cm$^2$, and light emission was not confirmed after 24 hours. Table 1 shows results of the measurement and results of the observation.

[Table 1]

| | | Spherical phosphor | | | $\Delta$Jsc (mA/cm$^2$) | Presence or absence of light emission after elapse of time under environment of 85°C and 85% RH | | |
|---|---|---|---|---|---|---|---|---|
| | | Content of fluorescent substance (%) | Volume average diameter ($\mu$m) | Amount of addition (parts) | | 0 hrs | 24 hrs | 2500 hrs |
| | Ex. 1 | 0.05 | 104 | 0.25 | 0.212 | Present | Present | Present |
| | Ex. 2 | 0.05 | 104 | 0.5 | 0.499 | Present | Present | Present |
| | Ex. 3 | 0.05 | 104 | 3 | 0.607 | Present | Present | Present |
| | Ex. 4 | 0.05 | 104 | 5 | 0.474 | Present | Present | Present |
| | Ex. 5 | 0.1 | 115 | 0.25 | 0.396 | Present | Present | Present |
| | Ex. 6 | 0.1 | 115 | 0.5 | 0.503 | Present | Present | Present |
| | Ex. 7 | 0.1 | 115 | 2 | 0.557 | Present | Present | Present |
| | Ex. 8 | 0.1 | 115 | 5 | 0.29 | Present | Present | Present |

(continued)

| | Spherical phosphor | | | ΔJsc (mA/cm$^2$) | Presence or absence of light emission after elapse of time under environment of 85°C and 85% RH | | |
|---|---|---|---|---|---|---|---|
| | Content of fluorescent substance (%) | Volume average diameter (μm) | Amount of addition (parts) | | 0 hrs | 24 hrs | 2500 hrs |
| Ex. 9 | 0.5 | 113 | 0.25 | 0.387 | Present | Present | Present |
| Ex. 10 | 0.5 | 113 | 0.5 | 0.431 | Present | Present | Present |
| Ex. 11 | 0.5 | 113 | 2 | 0.388 | Present | Present | Present |
| Ex. 12 | 0.5 | 113 | 3 | 0.295 | Present | Present | Present |
| Co. Ex. 1 | - | - | 0.01 | -0.18 | Present | Absent | Absent |

In Table 1, Content of fluorescent substance represents the content of the fluorescent substance in the spherical phosphor, and Amount of addition represents the number of parts of addition of the spherical phosphors (Examples 1 to 12) or the fluorescent substance (Comparative Example 1) with respect to 100 parts of the transparent sealing resin. Based on Table 1, formation of a photovoltaic cell module using the wavelength conversion-type photovoltaic cell sealing material including the spherical phosphor of the present invention has enabled light utilization efficiency in the photovoltaic cell module to be improved and has enabled electricity generation efficiency to be stably improved.

(Example 13)

<Synthesis of Fluorescent Substance>

In 25.0 g of methanol were dissolved 695.3 mg (2.24 mmol) of 1-(p-t-butylphenyl)-3-(p-methoxyphenyl)-1,3-propanedione (BMDBM) and 151.4 mg (0.84 mmol) of 1,10- phenanthroline (Phen). In this solution was dropped a solution of 109.2 mg (2.73 mmol) of sodium hydroxide in 10.0 g of methanol, and additionally, the mixture solution was stirred for 1 hour.
Next, a solution of 256.5 mg (0.7 mmol) of europium (III) chloride hexahydrate in 5.0 g of methanol was dropped, and then, the mixture solution was continuously stirred for 2 more hours. The produced precipitate was suctioned and filtered, washed with methanol, and then dried to obtain Eu (BMDBM) $_3$Phen that is a fluorescent substance.

<Synthesis of Spherical Phosphor>

A monomer solution was prepared by dissolving 42.9 mg (0.036 mmol, 0.10% by mass relative to the monomer) of the above fluorescent substance Eu(BMDBM)$_3$Phen and 214.3 mg (0.86 mmol) of 2,2'-azobis(2,4-dimethylvaleronitrile) (V-65) in 42.43 g of methyl methacrylate (MMA, a monomer component) and 0.43 g (1.0% by mass relative to the monomer) of 1,2,2,6,6-pentamethylpiperidinyl methacrylate (FA-711MM manufactured by Hitachi Chemical Co., Ltd.

The monomer solution was added in 300.00 g of an aqueous solution containing 0.42 g of polyvinyl alcohol, and the mixture solution was stirred at 3000 rpm using a homogenizer for 1 minute to prepare a suspension. The suspension was subjected to nitrogen bubbling at room temperature while being stirred by a stir blade at 350 rpm, followed by the increase of temperature to 50°C under nitrogen airflow and then, the polymerization of the suspension at that temperature for 4 hours. A part of particles thus obtained was collected to measure the presence or absence of light emission.
After that, to eliminate the remaining radical initiator, additionally the suspension temperature was increased up to 80°C and stirring was conducted for 2 hours to complete reaction, and then, the temperature of the reaction suspension was returned to room temperature. The produced spherical phosphor was filtered, sufficiently washed with pure water, and then dried at 60°C to obtain a spherical phosphor.

In addition, methyl methacrylate forming the transparent material in the spherical phosphor was cured using the heat radical initiator, and regarding the cured product, a transmittance of light of 400 to 800 mn in the optical path length of 1 cm was measured to be 90% or more.

(Example 14)

A spherical phosphor was obtained by the same method as that of Example 13 except that the amount of the fluorescent substance Eu(BMDBM)$_3$Phen added was changed to 21.4 mg (0.018 mmol), 0.05% by mass relative to the monomer).

(Example 15)

A monomer solution was prepared by dissolving 42.9 mg (0.036 mmol, 0.10% by mass relative to the monomer) of the above fluorescent substance Eu(BMDBM)$_3$Phen and 214.3 mg (0.86 mmol) of 2,2'-azobis(2,4-dimethylvaleronitrile) (V-65) in 42.86 g of methyl methacrylate (MMA).

The monomer solution was added in 300.00 g of an aqueous solution containing 0.42 g of polyvinyl alcohol, and then, the mixture solution was stirred at 3000 rpm using the homogenizer for 1 minute to prepare a suspension. The suspension was subjected to nitrogen bubbling at room temperature while being stirred by the stir blade at 350 rpm, followed by the increase of temperature to 50°C under nitrogen airflow and then, the polymerization of the suspension at that temperature for 4 hours. A part of particles thus obtained was collected to measure the presence or absence of light emission.

After that, to eliminate the remaining radical initiator, additionally the suspension temperature was increased up to 80°C and stirring was conducted for 2 hours to complete reaction. Then, the temperature of the reaction suspension was returned to room temperature. The produced spherical phosphor was filtered, sufficiently washed with pure water, and dried at 60°C to obtain organic particles.

[Evaluation Method]

Hereinafter, a description will be given of a method for measuring each parameter measured in each Example.

1. Measurement of Particle Size Distribution (Volume Average Diameter)

Measurement was conducted using LS13320 manufactured by Beckman Coulter, Inc., as a particle size distribution analyzer, and water as a dispersion medium.

2. Measurement of Presence or Absence of Light Emission

With irradiation by a UV (365 nm) lamp, light emission of the particles was confirmed by visual observation.
[Table 2]

| | | Ex.13 | Ex. 14 | Ex. 15 |
|---|---|---|---|---|
| Concentration of fluorescent substance (Eu complex) (% by mass relative to monomer) | | 0.1 | 0.05 | 0.1 |
| Radical scavenger (% by mass relative to monomer) | | 1 | 1 | None |
| Volume average diameter (μm) | | 128 | 118 | - |
| Presence or absence of light emission | After increase of temperature (to 50°C) | Present | Present | Absent |
| | End product | Present | Present | Absent |

As shown in Table 2, it is apparent that, by including a radical scavenger, there can be obtained a spherical phosphor emitting light despite the use of the fluorescent substance that significantly deteriorates due to radicals.

<Preparation of Resin Composition for Wavelength Conversion-Type Photovoltaic cell Sealing Material>

A mixture product containing 100 g of ULTRASEN 634: the ethylene-vinyl acetate resin manufactured by Tosoh Corporation, as the transparent sealing resin (dispersion medium resin), 1.3 g of LUPEROX 101: the peroxide heat radical initiator manufactured by Arkema Yoshitomi, Ltd., 2.00 g of TAIC (triallylisocyanate): a crosslinking agent manufactured by Nippon Kasei Chemical Co., Ltd., 0.5 g of SZ6030: the silane coupling agent manufactured by Toray Dow Corning Co. Ltd., and 3.00 g of the spherical phosphor of Example 13 was mixed and kneaded by the roll mixer adjusted to 90°C to obtain a resin composition for wavelength conversion-type photovoltaic cell sealing material.

<Production of Wavelength Conversion-Type Photovoltaic cell Sealing Material Sheet>

Approximately 30g of the resin composition for wavelength conversion-type photovoltaic cell sealing material obtained above was sandwiched by a release sheet to be formed into a sheet shape using the stainless steel spacer with the thickness of 0.6 mm and the press with a heat plate adjusted to 90°C. The obtained sheet-shaped wavelength conversion-type photovoltaic cell sealing material had the refractive index of 1.5.

<Production of Photovoltaic cell Sealing Material Sheet for Back Side>

In the production of the wavelength conversion-type photovoltaic cell sealing material sheet above, instead of the resin composition for wavelength conversion-type photovoltaic cell sealing material, using a resin composition prepared in the same manner as above except for including no spherical phosphor, a photovoltaic cell sealing material sheet for back side was produced by the same method as above.

<Production of Wavelength Conversion-Type Photovoltaic cell Module>

On a tempered glass (manufactured by Asahi Glass Co., Ltd., refractive index: 1.5) as a protection glass was mounted the wavelength conversion-type photovoltaic cell sealing material sheet, and thereon were mounted photovoltaic cells adapted to externally take out electromotive force such that the light receiving surfaces of the cells faced downwardly. Additionally, the photovoltaic cell sealing material sheet for back side and a PET film (trade name: A-4300 manufactured by Toyobo Co., Ltd.) as a back film were mounted and then, lamination was done using the vacuum laminator to produce a wavelength conversion-type photovoltaic cell module.
Additionally, on the photovoltaic cells used are formed a cell reflection preventing film with the refractive index of 1.9.

<Evaluation of Photovoltaic cell Characteristics>

Using the solar simulator (WXS-155S-10, AM 1.5 G, manufactured by Wacom Electric Co., Ltd.) as an artificial sunlight, a short-circuit current density Jsc in the state of the cells before module sealing and a short-circuit current density Jsc in the state thereof after module sealing, respectively, were measured by the I-V curve tracer (MP-160 manufactured by Eko Instruments, Co., Ltd.) electric current-voltage characteristics based on JIS-C8914, and a difference ($\Delta$Jsc) between them was obtained for evaluation. As a result, the $\Delta$Jsc was 0.423 mA/cm$^2$.

<Evaluation of High Temperature/High Humidity Resistance of Light Emission>

In the same method as in the <Production of Wavelength Conversion-Type Photovoltaic cell Module>, using a sheet of blue glass of 5 cm × 10 cm × 1 mm as a protection glass and thereon was mounted the wavelength conversion-type photovoltaic cell sealing material sheet. Then, as a back film, a PET film (trade name: A-4300 manufactured by Toyobo Co., Ltd.) was mounted thereon and lamination was done using the vacuum laminator to form a test piece. Using the handy UV lamp SLUV-4 manufactured by As One Corporation, the test piece was irradiated with light of 365 nm to observe the presence or absence of red light emission. In addition, the test piece was placed in the temperature and humidity testing chamber adjusted to 85°C and 85% RH, and after an appropriate time interval, the presence or absence of red light emission was observed in the same manner as above. As a result, light emission was confirmed until 2500 hours.

(Example 16)

<Synthesis of Fluorescent Substance>

In 7 ml of ethanol was dissolved 200 mg of 4,4,4-trifluoro-1-(thienyl)-1,3-butanedione (TTA), and into the solution was added 1.1 ml of 1M sodium hydroxide to mix together. Next, 6.2 mg of 1,10-phenanthroline dissolved in 7 ml of ethanol was added to the previous mixture solution After stirring the solution for 1 hour, a 3.5 ml aqueous solution of 103 mg of EuCl$_3$ · 6H$_2$O was added to obtain a precipitate. The precipitate was filtered, washed with ethanol, and dried to obtain a fluorescent substance Eu(TTA)$_3$Phen (phenanthroline-based europium complex).

<Production of Spherical Phosphor>

Amounts of 0.05 g of the fluorescent substance Eu(TTA)$_3$Phen obtained above, 95 g of methyl methacrylate, 5 g of ethylene glycol dimethacrylate, and 0.5 g of 2,2'-azobis(2,4-dimethylvaleronitrile) as a heat radical initiator, respectively, were measured and placed in a 200 ml screw tube to stir and mix using the ultrasonic cleaner and the mix rotor. In a separable flask equipped with a cooling tube were placed 500 g of deionized water and 59.1 g of polyvinyl alcohol 1.69% solution as a surfactant to stir the mixture solution. The previously prepared mixture solution of methyl methacrylate and ethylene glycol dimethacrylate was added to the mixture solution to heat up to 50°C while stirring at 350 rpm to allow it to react for 4 hours. In the obtained suspension, particle diameter measurement was conducted using Beckman Coulter LS13320 (a high resolution-type laser diffraction/scattering particle size distribution analyzer, Beckman Coulter Inc.) to obtain the volume mean diameter of 104 μm. The precipitate was filtered, washed with deionized water, and dried at 60°C to obtain a spherical phosphor by suspension polymerization.

<Observation Through Scanning Electron Microscope>

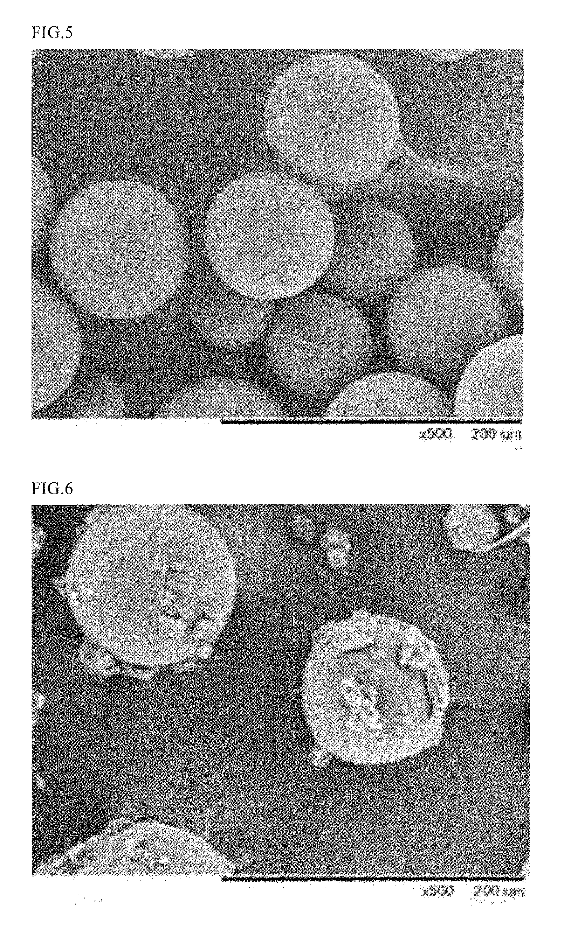

The obtained spherical phosphor was observed through a scanning electron microscope (acceleration voltage: 15 kV), and it was confirmed that the obtained spherical phosphor was spherical. A photograph of the scanning electron microscope was shown in FIG. 5.

<Measurement of Fluorescence Excitation Spectrum>

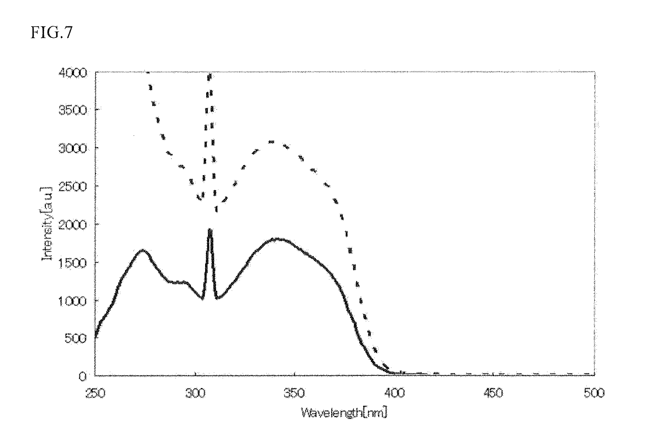

In addition, regarding the spherical phosphor, excitation spectrum at a fluorescence wavelength of 621 nm was measured by a fluorescence spectrophotometer manufactured by Hitachi Ltd. The excitation spectrum was shown as a broken line in FIG. 7.

<Preparation of Resin Composition for Wavelength Conversion-Type Photovoltaic cell Sealing Material>

A mixture product containing 100 g of ULTRASEN 634 (MFR = 4.3; content of vinyl acetate = 26%): the ethylene-vinyl acetate resin manufactured by Tosoh Corporation as the transparent sealing resin (dispersion medium resin), 1.5 g of LUPEROX 101 (2,5-dimethyl-2,5-di(t-butylperoxy)hexane: the peroxide heat radical initiator manufactured by Arkema Yoshitomi, Ltd., 0.5 g of SZ6030 (3-methacryloxypropyl trimethoxysilane): the silane coupling agent manufactured by Toray Dow Corning Co. Ltd., and 1.0 g of the spherical phosphor was mixed and kneaded by the roll mixer adjusted to 100°C to obtain a resin composition for wavelength conversion-type photovoltaic cell sealing material.

<Production of Wavelength Conversion-Type Photovoltaic cell Sealing Material Sheet>

Approximately 30g of the resin composition for wavelength conversion-type photovoltaic cell sealing material obtained above was sandwiched by a release sheet to be formed into a sheet shape using the stainless steel spacer with the thickness of 0.6 mm and the press with a heat plate adjusted to 80°C. The obtained sheet-shaped wavelength conversion-type photovoltaic cell sealing material had the refractive index of 1.5.

<Production of Photovoltaic cell Sealing Material Sheet for Back Side>

In the production of the wavelength conversion-type photovoltaic cell sealing material sheet above, instead of the resin composition for wavelength conversion-type photovoltaic cell sealing material, using a resin composition prepared in the same manner as above except for including no spherical phosphor, a photovoltaic cell sealing material sheet for back side was produced by the same method as above.

<Production of Wavelength Conversion-Type Photovoltaic cell Module>

On a tempered glass (manufactured by Asahi Glass Co., Ltd., refractive index: 1.5) as a protection glass was mounted the wavelength conversion-type photovoltaic cell sealing material sheet, and thereon were mounted photovoltaic cells adapted to externally take out electromotive force such that the light receiving surfaces of the cells faced downwardly. Additionally, the photovoltaic cell sealing material sheet for back side and a PET film (trade name: A-4300 manufactured by Toyobo Co., Ltd.) as a back film were mounted and then, lamination was done using the vacuum laminator to produce a wavelength conversion-type photovoltaic cell module.
Additionally, on the photovoltaic cells used are formed a cell reflection preventing film with the refractive index of 1.9.

<Evaluation of Photovoltaic cell Characteristics>

Using the solar simulator (WXS-1555-10, AM 1.5 G, manufactured by Wacom Electric Co., Ltd.) as an artificial sunlight, a short-circuit current density Jsc in the state of the cells before module sealing and a short-circuit current density Jsc in the state thereof after module sealing, respectively, were measured by the I-V curve tracer (MP-160 manufactured by Eko Instruments, Co., Ltd.) electric current-voltage characteristics based on JIS-C8914, and a difference (ΔJsc) between them was obtained for evaluation. As a result, the ΔJsc was 0.478 mA/cm$^2$.

(Example 17)

A spherical phosphor was obtained in all the same methods as in the <Production of Spherical Phosphor> of Example 16 except that the bi- or higher-functional vinyl compound (ethylene glycol dimethacrylate) was not used and the amount of methyl methacrylate was 100 g. Hereinbelow, in the same methods as those above, there were conducted <Observation Through Scanning Electron Microscope> <Measurement of Fluorescence Excitation Spectrum> <Preparation of Resin Composition for Wavelength Conversion-Type Photovoltaic cell Sealing Material> <Production of Wavelength Conversion-Type Photovoltaic cell Sealing Material Sheet> <Production of Photovoltaic cell Sealing Material Sheet for Back Side> <Production of Wavelength Conversion-Type Photovoltaic cell Module>and <Evaluation of Photovoltaic cell Characteristics>.
A scanning electron microscope photograph was shown in FIG. 6, and a fluorescence excitation spectrum was shown as a solid line in FIG. 7. The ΔJsc was 0.212 mA/cm$^2$.
Formation of a photovoltaic cell module using a wavelength conversion-type photovoltaic cell sealing material including the spherical phosphor of the present invention has enabled light utilization efficiency in the photovoltaic cell module to be further improved and has enabled electricity generation efficiency to be more stably improved.

**Claims**

1. A spherical phosphor comprising a fluorescent substance and a transparent material.

2. The spherical phosphor according to claim 1, wherein the fluorescent substance is an organic phosphor or a rare earth metal complex.

3. The spherical phosphor according to claim 1 or 2, wherein the fluorescent substance is a rare earth metal complex.

4. The spherical phosphor according to any one of claims 1 to 3, wherein the fluorescent substance is a europium complex.

5. The spherical phosphor according to any one of claims 1 to 4, wherein the transparent material is a transparent resin.

6. The spherical phosphor according to any one of claims 1 to 5, wherein the transparent material is a transparent vinyl resin.

7. The spherical phosphor according to any one of claims 1 to 6, wherein the transparent material is a transparent (meth)acrylic resin.

8. The spherical phosphor according to any one of claims 1 to 7, wherein a refractive index of the transparent material is lower than that of the fluorescent substance and is 1.4 or higher.

9. The spherical phosphor according to any one of claims 1 to 8, wherein the spherical phosphor comprises spherical resin particles obtained by emulsion polymerization or suspension polymerization of a vinyl compound composition in which the fluorescent substance is dissolved or dispersed.

10. The spherical phosphor according to any one of claims 1 to 9, wherein the spherical phosphor comprises spherical resin particles obtained by suspension polymerization of the vinyl compound composition in which the fluorescent substance is dissolved or dispersed.

11. The spherical phosphor according to claim 9 or 10, wherein the vinyl compound composition includes a bi- or higher-functional vinyl compound.

12. The spherical phosphor according to claim 11, wherein the vinyl compound composition includes a monofunctional (meth)acrylic acid derivative and a bi- or higher-functional (meth)acrylic acid derivative as vinyl compounds.

13. The spherical phosphor according to any one of claims 1 to 12, further comprising a radical scavenger.

14. A wavelength conversion-type photovoltaic cell sealing material comprising a light-transmissive resin composition layer including the spherical phosphor according to any one of claims 1 to 13 and a sealing resin.

15. The wavelength conversion-type photovoltaic cell sealing material according to claim 14, wherein a content of the spherical phosphor in the resin composition layer is 0.0001 to 10% by mass.

16. The wavelength conversion-type photovoltaic cell sealing material according to claim 14 or 15, further comprising a light transmissive layer other than the resin composition layer.

17. The wavelength conversion-type photovoltaic cell sealing material according to claim 16, comprising m layers including the resin composition layer and the light transmissive layer other than the resin composition layer, wherein when respective refractive indices of the m layers are $n_1$, $n_2$, $\cdots$, $n_{(m-1)}$, and $n_m$ in sequential order from a light incident side, then $n_1 \leq n_2 \leq \cdots \leq n_{(m-1)} \leq n_m$.

18. A photovoltaic cell module comprising a photovoltaic cell and the wavelength conversion-type photovoltaic cell sealing material according to any one of claims 14 to 17 disposed on a light receiving surface of the photovoltaic cell.

19. A method for producing the wavelength conversion-type photovoltaic cell sealing material according to any one of claims 14 to 17, the method comprising preparing the spherical phosphor according to any one of claims 1 to 13: preparing a resin composition in which the spherical phosphor is mixed or dispersed in a sealing resin; and forming the resin composition into a sheet shape to produce a light transmissive resin composition layer.

20. A method for producing the photovoltaic cell module according to claim 18, comprising preparing the wavelength conversion-type photovoltaic cell sealing material according to any one of claims 14 to 17 and disposing the wavelength conversion-type photovoltaic cell sealing material on the light receiving surface side of the photovoltaic cell.

FIG.1

FIG.2

$n_1 < n_2$

$n_1$

$n_2$

Critical angle

$$\theta_c = \sin^{-1}(n_1/n_2)$$

FIG.3

FIG.4

FIG.5

FIG.6

FIG.7

### INTERNATIONAL SEARCH REPORT

| International application No. |
|---|
| PCT/JP2011/058934 |

**A. CLASSIFICATION OF SUBJECT MATTER**
*C09K11/06*(2006.01)i, *C08F2/44*(2006.01)i, *C08K3/10*(2006.01)i, *C08L101/00*(2006.01)i, *C09K3/10*(2006.01)i, *H01L31/042*(2006.01)i

According to International Patent Classification (IPC) or to both national classification and IPC

**B. FIELDS SEARCHED**

Minimum documentation searched (classification system followed by classification symbols)
C09K11/06, C08F2/44, C08K3/10, C08L101/00, C09K3/10, H01L31/042

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2011 |
| Kokai Jitsuyo Shinan Koho | 1971–2011 | Toroku Jitsuyo Shinan Koho | 1994–2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2010/001703 A1 (Hitachi Chemical Co., Ltd.),<br>07 January 2010 (07.01.2010),<br>claims; paragraph [0077]<br>& JP 2010-34502 A | 1-4,8,14-20<br>5-7,9-13 |
| X<br>A | JP 2009-13186 A (Mitsubishi Chemical Corp.),<br>22 January 2009 (22.01.2009),<br>claims; paragraph [0018]<br>(Family: none) | 1-3<br>4-20 |
| X<br>A | JP 2007-308548 A (Yamaguchi University et al.),<br>29 November 2007 (29.11.2007),<br>claims; paragraph [0022]<br>(Family: none) | 1,5-13<br>2-4,14-20 |

☒ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 28 June, 2011 (28.06.11) | 12 July, 2011 (12.07.11) |

| Name and mailing address of the ISA/<br>Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2011/058934

| C (Continuation). DOCUMENTS CONSIDERED TO BE RELEVANT | | |
|---|---|---|
| Category* | Citation of document, with indication, where appropriate, of the relevant passages | Relevant to claim No. |
| X<br>A | WO 2008/102418 A1 (Sanyo Chemical Industries,<br>Ltd.),<br>28 August 2008 (28.08.2008),<br>claims<br>& CN 101606089 A        & JP 2008-230218 A<br>& JP 2008-231401 A        & JP 2008-255317 A<br>& JP 2008-255318 A        & KR 10-2009-0121330 A<br>& US 2009/0269579 A1 | 1,5-13<br>2-4,14-20 |
| X<br>A | JP 2006-322001 A (Samsung Electro-Mechanics<br>Co., Ltd.),<br>30 November 2006 (30.11.2006),<br>claims<br>& KR 10-2006-0118161 A  & US 2007/0087197 A1 | 1<br>2-20 |
| X<br>A | JP 2008-280471 A (Sony Corp.),<br>20 November 2008 (20.11.2008),<br>claims<br>(Family: none) | 1<br>2-20 |
| X<br>A | JP 2008-19380 A (Toshiba Corp.),<br>31 January 2008 (31.01.2008),<br>claims<br>(Family: none) | 1<br>2-20 |
| P,X<br>P,A | JP 2011-14725 A (Hitachi Chemical Co., Ltd.<br>et al.),<br>20 January 2011 (20.01.2011),<br>claims<br>(Family: none) | 1-4,8,14-20<br>5-7,9-13 |
| P,A | WO 2011/040391 A1 (Hitachi Chemical Co., Ltd.),<br>07 April 2011 (07.04.2011),<br>claims; examples<br>(Family: none) | 1-20 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000328053 A
- JP 2006303033 A
- JP 2003051605 A
- JP 2010090351 A
- JP 2010229914 A
- JP 2010184932 A

**Non-patent literature cited in the description**

- **MASAYA MITSUISHI ; SHINJI KIKUCHI ; TOKUJI MIYASHITA ; YUTAKA AMANO.** *J. Master. Chem.,* 2003, vol. 13, 285-2879